# EUROPEAN PATENT APPLICATION

(11) **EP 4 001 364 A1**
(43) Date of publication of application: **25.05.2022**
(21) Application number: 20840859.1
(22) Date of filing: 23.06.2020
(51) Int. Cl.: C09D 5/16, C09D 183/04, C09K 3/18, C09D 7/63

(54) **SURFACE TREATMENT AGENT**

(30) Priority: 17.07.2019 JP 2019132027
(71) Applicant: Daikin Industries, Ltd., Osaka-shi, Osaka 530-8323 (JP)
(72) Inventor: NOMURA, Takashi, Osaka-shi, Osaka 530-8323 (JP); NAITOU, Masato, Osaka-shi, Osaka 530-8323 (JP); OZAWA, Kaori, Osaka-shi, Osaka 530-8323 (JP); NAKANO, Nozomi, Osaka-shi, Osaka 530-8323 (JP); MITSUHASHI, Hisashi, Osaka-shi, Osaka 530-8323 (JP)
(74) Representative: Hoffmann Eitle
(86) International application number: PCT/JP2020/024623
(87) International publication number: WO 2021/010105

(57) **Abstract**

The present invention provides a surface-treating agent comprising: a fluorine-containing silane compound; and a metal compound, wherein a metal atom contained in the metal compound is one or more metal atoms selected from transition metal atoms of Groups 3 to 11 and typical metal atoms of Groups 12 to 15 of the periodic table.

## Description

### Technical Field

The present disclosure relates to a surface-treating agent and an article having a layer formed of the surface-treating agent.

### Background Art

Certain types of fluorine-containing silane compounds are known to be capable of providing excellent water-repellency, oil-repellency, antifouling properties, and the like when used in surface treatment of a substrate. A layer obtained from a surface-treating agent containing a fluorine-containing silane compound (hereinafter, also referred to as a "surface-treating layer") is applied as a so-called functional thin film to a large variety of substrates such as glass, plastics, fibers, sanitary articles, and building materials (Patent Literatures 1 and 2) .

### Prior Art Literature

### Patent Literature

Patent Literature 1: JP 2014-218639 A
Patent Literature 2: JP 2017-082194 A

### Summary of Invention

### Technical Problem

The fluorine-containing silane compound described in Patent Literature 1 or Patent Literature 2 can provide a surface-treating layer having an excellent function, but a surface-treating layer having higher friction durability and chemical resistance is required.

An object of the present disclosure is to provide an article having a surface-treating layer having higher friction durability and chemical resistance.

### Solution to Problem

The present disclosure includes the following embodiments.
[1] A surface-treating agent comprising: a fluorine-containing silane compound; and a metal compound, wherein a metal atom contained in the metal compound is one or more metal atoms selected from transition metal atoms of Groups 3 to 11 and typical metal atoms of Groups 12 to 15 of the periodic table.
[2] The surface-treating agent according to [1], wherein the fluorine-containing silane compound is at least one fluoropolyether group-containing compound represented by the following formula (1) or (2):

   **R^{F1}_{α}-X^{A} - R^{Si}_{β}** **(1)**

   **R^{Si}_{γ} - X^{A} - R^{F2} - X^{A} - R^{Si}_{γ}** **(2)**

   wherein
   R^{F1} is each independently at each occurrence Rf¹-R^{F}-O_{q}-;
   R^{F2} is -Rf²ₚ-R^{F}-O_{q}-;
   Rf¹ is each independently at each occurrence a C₁₋₁₆ alkyl group optionally substituted with one or more fluorine atoms;
   Rf² is a C₁₋₆ alkylene group optionally substituted with one or more fluorine atoms;
   R^{F} is each independently at each occurrence a divalent fluoropolyether group;
   p is 0 or 1;
   q is each independently at each occurrence 0 or 1;
   R^{Si} is each independently at each occurrence a monovalent group containing a Si atom to which a hydroxyl group, a hydrolyzable group, a hydrogen atom or a monovalent organic group is bonded;
   at least one R^{Si} is a monovalent group containing a Si atom to which a hydroxyl group or a hydrolyzable group is bonded;
   X^{A} is each independently a single bond or a di- to decavalent organic group;
   α is an integer of 1 to 9;
   β is an integer of 1 to 9; and
   γ is each independently an integer of 1 to 9.
[3] The surface-treating agent according to [2], wherein Rf¹ is each independently at each occurrence a C₁₋₁₆ perfluoroalkyl group; and
   Rf² is each independently at each occurrence a C₁₋₆ perfluoroalkylene group.
[4] The surface-treating agent according to [2] or [3], wherein R^{F} is each independently at each occurrence a group represented by formula:

   -(OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

   wherein R^{Fa} is each independently at each occurrence a hydrogen atom, fluorine atom, or a chlorine atom; and
   a, b, c, d, e and f are each independently an integer of 0 to 200, the sum of a, b, c, d, e and f is 1 or more, and the occurrence order of the respective repeating units enclosed in parentheses provided with a, b, c, d, e or f is not limited in the formula.
[5] The surface-treating agent according to [4], wherein R^{Fa} is a fluorine atom.
[6] The surface-treating agent according to any one of [2] to [5], wherein R^{F} is each independently at each occurrence a group represented by the following formula (f1), (f2), (f3), (f4), or (f5):

   -(OC₃F₆)_{d}- (f1)

   wherein d is an integer of 1 to 200;

   -(OC₄F₈)_{c}-(OC₃F₆)_{d}-(OC₂F₄)ₑ-(OCF₂)_{f}- (f2)

   wherein c and d are each independently an integer of 0 to 30;
   e and f are each independently an integer of 1 to 200;
   the sum of c, d, e, and f is an integer of 10 to 200; and
   the occurrence order of the respective repeating units enclosed in parentheses provided with a subscript c, d, e, or f is not limited in the formula;

   - (R⁶-R⁷)_{g}- (f3)

   wherein R⁶ is OCF₂ or OC₂F₄;
   R⁷ is a group selected from OC₂F₄, OC₃F₆, OC₄F₈, OC₅F₁₀, and OC₆F₁₂, or is a combination of two or three groups selected from these groups; and
   g is an integer of 2 to 100;
   -(OC₆F₁₂)ₐ-(OC₅F₁₀)_{b}-(OC₄F₈)_{c}-(OC₃F₆)_{d}-(OC₂F₄)ₑ-(OCF₂)_{f}- (f4)

   wherein e is an integer of 1 or more and 200 or less, a, b, c, d and f are each independently an integer of 0 or more and 200 or less, the sum of a, b, c, d, e and f is at least 1, and the occurrence order of the respective repeating units enclosed in parentheses provided with a, b, c, d, e or f is not limited in the formula; and

   -(OC₆F₁₂)ₐ-(OC₅F₁₀)_{b}-(OC₄F₈)_{c}-(OC₃F₆)_{d}-(OC₂F₄)ₑ-(OCF₂)_{f}- (f5)

   wherein f is an integer of 1 or more and 200 or less, a, b, c, d, and e are each independently an integer of 0 or more and 200 or less, the sum of a, b, c, d, e and f is at least 1, and the occurrence order of the respective repeating units enclosed in parentheses provided with a, b, c, d, e or f is not limited in the formula.
[7] The surface-treating agent according to any one of [2] to [6], wherein R^{Si} is a group represented by the following formula (S1), (S2), (S3), or (S4):

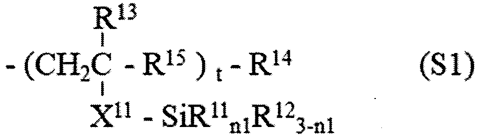

   - **SiR¹¹ₙ₁R¹²₃₋ₙ₁** **(S2)**

   - **SiR^{a1}ₖ₁R^{b1}₁₁R^{c1}ₘ₁** **(S3)**

   - **CR^{d1}ₖ₂R^{e1}₁₂R^{f1}ₘ₂** **(S4)**

   wherein
   R¹¹ is each independently at each occurrence a hydroxyl group or a hydrolyzable group;
   R¹² is each independently at each occurrence a hydrogen atom or a monovalent organic group;
   n1 is an integer of 0 to 3 each independently in each (SiR¹¹ₙ₁R¹² ₃₋ₙ₁) unit;
   X¹¹ is each independently at each occurrence a single bond or a divalent organic group;
   R¹³ is each independently at each occurrence a hydrogen atom or a monovalent organic group;
   t is each independently at each occurrence an integer of 2 or more;
   R¹⁴ is each independently at each occurrence a hydrogen atom, a halogen atom, or -X¹¹-SiR¹¹ₙ₁R¹² ₃₋ₙ₁ ;
   R¹⁵ is each independently at each occurrence a single bond, an oxygen atom, an alkylene group having 1 to 6 carbon atoms or an alkyleneoxy group having 1 to 6 carbon atoms;
   R^{a1} is each independently at each occurrence -Z¹-SiR²¹ₚ₁R²²_{q1}R²³ᵣ₁;
   Z¹ is each independently at each occurrence an oxygen atom or a divalent organic group;
   R²¹ is each independently at each occurrence -Z^{1'}-SiR^{21'}_{p1'} R^{22 '}_{q1'} R^{23'}_{r1'} ;
   R²² is each independently at each occurrence a hydroxyl group or a hydrolyzable group;
   R²³ is each independently at each occurrence a hydrogen atom or a monovalent organic group;
   p1 is each independently at each occurrence an integer of 0 to 3;
   q1 is each independently at each occurrence an integer of 0 to 3;
   r1 is each independently at each occurrence an integer of 0 to 3;
   Z^{1'} is each independently at each occurrence an oxygen atom or a divalent organic group;
   R^{21'} is each independently at each occurrence -Z^{1"}-SiR^{22"}_{q1"}R^{23"}_{r1"};
   R^{22'} is each independently at each occurrence a hydroxyl group or a hydrolyzable group;
   R^{23'} is each independently at each occurrence a hydrogen atom or a monovalent organic group;
   p1' is each independently at each occurrence an integer of 0 to 3;
   q1' is each independently at each occurrence an integer of 0 to 3;
   r1' is each independently at each occurrence an integer of 0 to 3;
   Z^{1"} is each independently at each occurrence an oxygen atom or a divalent organic group;
   R^{22"} is each independently at each occurrence a hydroxyl group or a hydrolyzable group;
   R^{23"} is each independently at each occurrence a hydrogen atom or a monovalent organic group;
   q1" is each independently at each occurrence an integer of 0 to 3;
   r1" is each independently at each occurrence an integer of 0 to 3;
   R^{b1} is each independently at each occurrence a hydroxyl group or a hydrolyzable group;
   R^{c1} is each independently at each occurrence a hydrogen atom or a monovalent organic group;
   k1 is each independently at each occurrence an integer of 0 to 3;
   11 is each independently at each occurrence an integer of 0 to 3;
   m1 is each independently at each occurrence an integer of 0 to 3;
   R^{d1} is each independently at each occurrence -Z²-CR³¹ₚ₂R³²_{q2}R³³ᵣ₂ ;
   Z² is each independently at each occurrence a single bond, an oxygen atom or a divalent organic group;
   R³¹ is each independently at each occurrence -Z^{2'}-CR^{32'}_{q2'}R^{33'}_{r2'};
   R³² is each independently at each occurrence -Z³-SiR³⁴ₙ₂R³⁵₃₋ₙ₂;
   R³³ is each independently at each occurrence a hydrogen atom, a hydroxyl group, or a monovalent organic group;
   p2 is each independently at each occurrence an integer of 0 to 3;
   q2 is each independently at each occurrence an integer of 0 to 3;
   r2 is each independently at each occurrence an integer of 0 to 3;
   Z^{2'} is each independently at each occurrence a single bond, an oxygen atom or a divalent organic group;
   R^{32'} is each independently at each occurrence -Z³-SiR³⁴ₙ₂R³⁵₃₋ₙ₂;
   R^{33'} is each independently at each occurrence a hydrogen atom, a hydroxyl group, or a monovalent organic group;
   q2' is each independently at each occurrence an integer of 0 to 3;
   r2' is each independently at each occurrence an integer of 0 to 3;
   Z³ is each independently at each occurrence a single bond, an oxygen atom or a divalent organic group;
   R³⁴ is each independently at each occurrence a hydroxyl group or a hydrolyzable group;
   R³⁵ is each independently at each occurrence a hydrogen atom or a monovalent organic group;
   n2 is each independently at each occurrence an integer of 0 to 3;
   R^{e1} is each independently at each occurrence -Z³-SiR³⁴ₙ₂R³⁵₃₋ₙ₂;
   R^{f1} is each independently at each occurrence a hydrogen atom, a hydroxyl group, or a monovalent organic group;
   k2 is each independently at each occurrence an integer of 0 to 3;
   12 is each independently at each occurrence an integer of 0 to 3; and
   m2 is each independently at each occurrence an integer of 0 to 3.
[8] The surface-treating agent according to any one of [2] to [7], wherein α, β, and γ are 1.
[9] The surface-treating agent according to any one of [2] to [7], wherein X^{A} is each independently a trivalent organic group;
   α is 1 and β is 2, or α is 2 and β is 1; and
   γ is 2.
[10] The surface-treating agent according to any one of [7] to [9], wherein the group represented by the formula (S1) is a group represented by the formula (Sl-b): 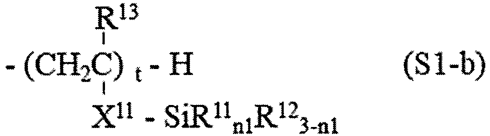 wherein R¹¹, R¹², R¹³, X¹¹, n1, and t have the same definition as described in the formula (S1).
[11] The surface-treating agent according to any one of [1] to [10], further comprising an alcohol.
[12] The surface-treating agent according to any one of [1] to [11], further comprising one or more other components selected from a fluorine-containing oil, a silicone oil, and a catalyst.
[13] The surface-treating agent according to any one of [1] to [12], further comprising a solvent.
[14] The surface-treating agent according to any one of [1] to [13], which is used as an antifouling coating agent or a water-proof coating agent.
[15] The surface-treating agent according to any one of [1] to [14], which is for vacuum deposition.
[16] A pellet comprising the surface-treating agent according to any one of [1] to [15].
[17] An article comprising: a substrate; and a layer formed on the substrate from the surface-treating agent according to any one of [1] to [15].
[18] An article comprising: a substrate; and a surface-treating layer formed on the substrate, wherein the surface-treating layer is formed from a fluorine-containing silane compound and comprises one or more metal atoms selected from transition metal atoms of Groups 3 to 11 and typical metal atoms of Groups 12 to 15 of the periodic table.
[19] The article according to [18], wherein the metal atom is contained in the surface-treating layer in an amount of 0.03 to 3 at% based on a total amount of carbon, oxygen, fluorine, silicon and the metal atom.
[20] The article according to [18] or [19], wherein the metal atom is one or more metal atoms selected from Ta, Nb, Zr, Mo, W, Cr, Hf, Al, Ti, and V.
[21] The article according to any one of [18] to [20], wherein the metal atom is Ta.
[22] The article according to any one of [18] to [21], wherein the fluorine-containing silane compound is at least one fluoropolyether group-containing compound represented by the following formula (1) or (2):

   **R^{F1}_{α}- X^{A} - R^{Si}_{β}** **(1)**

   **R^{Si}_{γ} - X^{A} - R^{F2}- X^{A} - R^{Si}_{γ}** **(2)**

   wherein
   R^{F1} is each independently at each occurrence Rf¹-R^{F}-O_{q}-;
   R^{F2} is -Rf²ₚ-R^{F}-O_{q}-;
   Rf¹ is each independently at each occurrence a C₁₋₁₆ alkyl group optionally substituted with one or more fluorine atoms;
   Rf² is a C₁₋₆ alkylene group optionally substituted with one or more fluorine atoms;
   R^{F} is each independently at each occurrence a divalent fluoropolyether group;
   p is 0 or 1;
   q is each independently at each occurrence 0 or 1;
   R^{Si} is each independently at each occurrence a monovalent group containing a Si atom to which a hydroxyl group, a hydrolyzable group, a hydrogen atom or a monovalent organic group is bonded;
   at least one R^{Si} is a monovalent group containing a Si atom to which a hydroxyl group or a hydrolyzable group is bonded;
   X^{A} is each independently a single bond or a di- to decavalent organic group;
   α is an integer of 1 to 9;
   β is an integer of 1 to 9; and
   γ is each independently an integer of 1 to 9.
[23] The article according to any one of [17] to [22], wherein the substrate is a glass substrate.
[24] The article according to any one of [17] to [23], which is an optical member.
[25] A method for producing an article comprising a substrate and a surface-treating layer formed on the substrate,
   wherein the surface-treating layer is formed from a fluorine-containing silane compound and comprises one or more metal atoms selected from transition metal atoms of Groups 3 to 11 and typical metal atoms of Groups 12 to 15 of the periodic table, and
   the method comprises depositing the fluorine-containing silane compound and a metal compound containing the metal atom on the substrate using a surface-treating agent containing the fluorine-containing silane compound and the metal compound containing the metal atom to form the surface-treating layer.

### Advantageous Effect of Invention

According to the present disclosure, it is possible to provide an article having a surface-treating layer having better friction durability and chemical resistance.

### Description of Embodiments

As used herein, the term "monovalent organic group" refers to a monovalent group containing carbon. The monovalent organic group is not limited, and may be a hydrocarbon group or a derivative thereof. The derivative of a hydrocarbon group refers to a group having one or more of N, O, S, Si, amide, sulfonyl, siloxane, carbonyl, carbonyloxy, and the like at the terminal of the hydrocarbon group or in the molecular chain thereof. The term "organic group" refers to a monovalent organic group. The term "di- to decavalent organic group" refers to a di- to decavalent group containing carbon. The di- to decavalent organic group may be, but is not limited to, a di- to decavalent group obtained by further removing 1 to 9 hydrogen atoms from an organic group. For example, the divalent organic group may be, but is not limited to, a divalent group obtained by further removing one hydrogen atom from an organic group.

The term "hydrocarbon group", as used herein, refers to a group that contains a carbon and a hydrogen and that is obtained by removing one hydrogen atom from a hydrocarbon. The hydrocarbon group is not limited, and examples include a C₁₋₂₀ hydrocarbon group optionally substituted with one or more substituents, such as an aliphatic hydrocarbon group and an aromatic hydrocarbon group. The "aliphatic hydrocarbon group" may be either linear, branched, or cyclic, and may be either saturated or unsaturated. The hydrocarbon group may contain one or more ring structures.

As used herein, the substituent of the "hydrocarbon group" is not limited, and examples thereof include one or more groups selected from a halogen atom; and a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, a 5 to 10-membered heterocyclyl group, a 5 to 10-membered unsaturated heterocyclyl group, a C₆₋₁₀ aryl group, and a 5 to 10-membered heteroaryl group, each of which is optionally substituted with one or more halogen atoms.

The surface-treating agent of the present disclosure includes a fluorine-containing silane compound and a metal compound.

The surface-treating agent of the present disclosure can provide a surface-treating layer having improved friction resistance and chemical resistance by further containing a metal compound in addition to a fluorine-containing silane compound.

### (Fluorine-containing silane compound)

The fluorine-containing silane compound is a compound containing fluorine and capable of forming a surface-treating layer having antifouling properties.

In one embodiment, the fluorine-containing silane compound is at least one fluoropolyether group-containing compound represented by the following formula (1) or (2):

**R^{F1}_{α} - X^{A} - R^{Si}_{β}** **(1)**

**R^{Si}_{γ} - X^{A} - R^{F2} - X^{A} - R^{Si}_{γ}** **(2)**

wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

In the formula (1), R^{F1} is each independently at each occurrence Rf¹-R^{F}-O_{q}-.

In the formula (2), R^{F2} is -Rf²ₚ-R^{F}-O_{q}-.

In the formula, Rf¹ is each independently at each occurrence a C₁₋₁₆ alkyl group optionally substituted with one or more fluorine atoms.

In the C₁₋₁₆ alkyl group optionally substituted with one or more fluorine atoms, the "C₁₋₁₆ alkyl group" may be linear or branched, and is preferably a linear or branched C₁₋₆ alkyl group, in particular C₁₋₃ alkyl group, and more preferably a linear C₁₋₆ alkyl group, in particular C₁₋₃ alkyl group.

Rf¹ is preferably a C₁₋₁₆ alkyl group substituted with one or more fluorine atoms, more preferably a CF₂H-C₁₋₁₅ perfluoroalkylene group, and still more preferably a C₁₋₁₆ perfluoroalkyl group.

The C₁₋₁₆ perfluoroalkyl group may be linear or branched, and is preferably a linear or branched C₁₋₆ perfluoroalkyl group, in particular C₁₋₃ perfluoroalkyl group, more preferably a linear C₁₋₆ perfluoroalkyl group, in particular C₁₋₃ perfluoroalkyl group, and specifically - CF₃, -CF₂CF₃, or -CF₂CF₂CF₃.

In the formula, Rf² is a C₁₋₆ alkylene group optionally substituted with one or more fluorine atoms.

In the C₁₋₆ alkylene group optionally substituted with one or more fluorine atoms, the "C₁₋₆ alkylene group" may be linear or branched, and is preferably a linear or branched C₁₋₃ alkylene group, and more preferably a linear C₁₋₃ alkylene group.

The Rf² is preferably a C₁₋₆ alkylene group substituted with one or more fluorine atoms, more preferably a C₁₋₆ perfluoroalkylene group, and still more preferably a C₁₋₃ perfluoroalkylene group.

The C₁₋₆ perfluoroalkylene group may be linear or branched, and is preferably a linear or branched C₁₋₃ perfluoroalkylene group, more preferably a linear C₁₋₃ perfluoroalkyl group, and specifically -CF₂-, -CF₂CF₂-, or - CF₂CF₂CF₂- .

In the formula, p is 0 or 1. In one embodiment, p is 0. In another embodiment, p is 1.

In the formula, q is each independently at each occurrence 0 or 1. In one embodiment, q is 0. In another embodiment, q is 1.

In the formulas (1) and (2), R^{F} is each independently at each occurrence a divalent fluoropolyether group.

R^{F} is preferably a group represented by the following formula:

- (OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

wherein
R^{Fa} is each independently at each occurrence a hydrogen atom, fluorine atom, or a chlorine atom;
a, b, c, d, e and f are each independently an integer of 0 to 200, and the sum of a, b, c, d, e and f is 1 or more; and the occurrence order of the respective repeating units enclosed in parentheses provided with a, b, c, d, e or f is not limited in the formula, provided that when all R^{Fa} are a hydrogen atom or a chlorine atom, at least one of a, b, c, e, and f is 1 or more.

R^{Fa} is preferably a hydrogen atom or a fluorine atom, and more preferably a fluorine atom, provided that when all R^{Fa} are a hydrogen atom or a chlorine atom, at least one of a, b, c, e, and f is 1 or more.

a, b, c, d, e and f may preferably each independently be an integer of 0 to 100.

The sum of a, b, c, d, e and f is preferably 5 or more, and more preferably 10 or more, for example, 15 or more, or 20 or more. The sum of a, b, c, d, e and f is preferably 200 or less, and more preferably 100 or less, and still more preferably 60 or less, for example, 50 or less, or 30 or less.

These repeating units may be linear or branched. For example, -(OC₆F₁₂)- may be -(OCF₂CF₂CF₂CF₂CF₂CF₂)-, - (OCF(CF₃) CF₂CF₂CF₂CF₂) -, - (OCF₂CF (CF₃)CF₂CF₂CF₂) -, - (OCF₂CF₂CF (CF₃) CF₂CF₂) -, - (OCF₂CF₂CF₂CF (CF₃) CF₂)-, - (OCF₂CF₂CF₂CF₂CF(CF₃))-, or the like. - (OC₅F₁₀) - may be - (OCF₂CF₂CF₂CF₂CF₂) -, - (OCF (CF₃)CF₂CF₂CF₂) -, - (OCF₂CF(CF₃)CF₂CF₂)-, -(OCF₂CF₂CF(CF₃)CF₂)-, - (OCF₂CF₂CF₂CF(CF₃))-, or the like. -(OC₄F₈)- may be any of - (OCF₂CF₂CF₂CF₂)-, -(OCF(CF₃)CF₂CF₂)-, -(OCF₂CF(CF₃)CF₂)-, - (OCF₂CF₂CF(CF₃))-, -(OC(CF₃)₂CF₂)-, -(OCF₂C(CF₃)₂)-, - (OCF(CF₃)CF(CF₃))-, -(OCF(C₂F₅)CF₂)-, and -(OCF₂CF(C₂F₅))-. -(OC₃F₆)- (that is, in the formula, R^{Fa} is a fluorine atom) may be any of -(OCF₂CF₂CF₂)-, -(OCF(CF₃)CF₂)-, and - (OCF₂CF(CF₃))-. -(OC₂F₄)- may be any of - (OCF₂CF₂) - and - (OCF (CF₃)) -.

In one embodiment, the repeating unit is linear. When the repeating unit is linear, the surface lubricity and friction durability and the like of the surface-treating layer can be improved.

In one embodiment, the repeating unit is branched. When the repeating unit is branched, the dynamic friction coefficient of the surface-treating layer can be increased.

In one embodiment, R^{F} is each independently at each occurrence a group represented by any of the following formulas (f1) to (f5):

-(OC₃F₆)_{d}- (f1)

wherein d is an integer of 1 to 200;

-(OC₄F₈)_{c}-(OC₃F₆)_{d}-(OC₂F₄)ₑ-(OCF₂)_{f}- (f2)

wherein c and d are each independently an integer of 0 or more and 30 or less, e and f are each independently an integer of 1 or more and 200 or less;
the sum of c, d, e, and f is 2 or more; and
the occurrence order of the respective repeating units enclosed in parentheses provided with a subscript c, d, e, or f is not limited in the formula;

- (R⁶-R⁷)_{g}- (f3)

wherein R⁶ is OCF₂ or OC₂F₄;
R⁷ is a group selected from OC₂F₄, OC₃F₆, OC₄F₈, OC₅F₁₀, and OC₆F₁₂, or a combination of two or three groups independently selected from these groups; and
g is an integer of 2 to 100;

-(OC₆F₁₂)ₐ-(OC₅F₁₀)_{b}-(OC₄F₈)_{c}-(OC₃F₆)_{d}-(OC₂F₄)ₑ-(OCF₂)_{f}- (f4)

wherein e is an integer of 1 or more and 200 or less, a, b, c, d and f are each independently an integer of 0 or more and 200 or less, and the occurrence order of the respective repeating units enclosed in parentheses provided with a, b, c, d, e or f is not limited in the formula; and

-(OC₆F₁₂)ₐ-(OC₅F₁₀)_{b}-(OC₄F₈)_{c}-(OC₃F₆)_{d}-(OC₂F₄)ₑ-(OCF₂)_{f}- (f5)

wherein f is an integer of 1 or more and 200 or less, a, b, c, d, and e are each independently an integer of 0 or more and 200 or less, and the occurrence order of the respective repeating units enclosed in parentheses provided with a, b, c, d, e or f is not limited in the formula.

In the formula (f1), d is preferably an integer of 5 to 200, more preferably 10 to 100, still more preferably 15 to 50, for example 25 to 35. The formula (f1) is preferably a group represented by -(OCF₂CF₂CF₂)_{d}- or - (OCF(CF₃)CF₂)_{d}-, and more preferably a group represented by - (OCF₂CF₂CF₂)_{d}- .

In the formula (f2), e and f are each independently, preferably an integer of 5 to 200, and more preferably 10 to 200. Further, the sum of c, d, e and f is preferably 5 or more, and more preferably 10 or more, for example, 15 or more, or 20 or more. In one embodiment, the formula (f2) is preferably a group represented by -(OCF₂CF₂CF₂CF₂)_{c}-(OCF₂CF₂CF₂)_{d}-(OCF₂CF₂)ₑ-(OCF₂)_{f}-. In another embodiment, the formula (f2) may be a group represented by -(OC₂F₄)ₑ-(OCF₂)_{f}-.

In the formula (f3), R⁶ is preferably OC₂F₄. In the formula (f3), R⁷ is preferably a group selected from OC₂F₄, OC₃F₆, and OC₄F₈, or a combination of two or three groups independently selected from these groups, and more preferably a group selected from OC₃F₆ and OC₄F₈. Examples of the combination of 2 or 3 groups independently selected from OC₂F₄, OC₃F₆, and OC₄F₈ include, but are not limited to, -OC₂F₄OC₃F₆-, -OC₂F₄OC₄F₈-, -OC₃F₆OC₂F₄-, -OC₃F₆OC₃F₆-, - OC₃F₆OC₄F₈-, -OC₄F₈OC₄F₈-, -OC₄F₈OC₃F₆-, -OC₄F₈OC₂F₄-, - OC₂F₄OC₂F₄OC₃F₆-, -OC₂F₄OC₂F₄OC₄F₈-, -OC₂F₄OC₃F₆OC₂F₄-, - OC₂F₄OC₃F₆OC₃F₆-, -OC₂F₄OC₄F₈OC₂F₄-, -OC₃F₆OC₂F₄OC₂F₄-, - OC₃F₆OC₂F₄OC₃F₆-, -OC₃F₆OC₃F₆OC₂F₄-, and -OC₄F₈OC₂F₄OC₂F₄-. In the formula (f3), g is preferably an integer of 3 or more, and more preferably 5 or more. g is preferably an integer of 50 or less. In the formula (f3), OC₂F₄, OC₃F₆, OC₄F₈, OC₅F₁₀, and OC₆F₁₂ may be either linear or branched, and are preferably linear. In this embodiment, the formula (f3) is preferably - (OC₂F₄-OC₃F₆)_{g}- or - (OC₂F₄-OC₄F₈)_{g}-.

In the formula (f4), e is preferably an integer of 1 or more and 100 or less, and more preferably 5 or more and 100 or less. The sum of a, b, c, d, e and f is preferably 5 or more, and more preferably 10 or more, such as 10 or more and 100 or less.

In the formula (f5), f is preferably an integer of 1 or more and 100 or less, and more preferably 5 or more and 100 or less. The sum of a, b, c, d, e and f is preferably 5 or more, and more preferably 10 or more, such as 10 or more and 100 or less.

In one embodiment, R^{F} is a group represented by the formula (f1).

In one embodiment, R^{F} is a group represented by the formula (f2).

In one embodiment, R^{F} is a group represented by the formula (f3).

In one embodiment, R^{F} is a group represented by the formula (f4).

In one embodiment, R^{F} is a group represented by the formula (f5).

The ratio of e to f in R^{F} (hereinafter, referred to as an "e/f ratio") is 0.1 to 10, preferably 0.2 to 5, more preferably 0.2 to 2, still more preferably 0.2 to 1.5, and further preferably 0.2 to 0.85. With an e/f ratio of 10 or less, the lubricity, friction durability, and chemical resistance (such as durability against artificial sweat) of a surface-treating layer obtained from the compound are further increased. The smaller the e/f ratio is, the higher the lubricity and the friction durability of the surface-treating layer are. On the other hand, with an e/f ratio of 0.1 or more, the stability of the compound can be further increased. The larger the e/f ratio is, the higher the stability of the compound is.

In one embodiment, the e/f ratio is preferably 0.2 to 0.95, and more preferably 0.2 to 0.9.

In one embodiment, from the viewpoint of heat resistance, the e/f ratio is preferably 1.0 or more, and more preferably 1.0 to 2.0.

In the fluoropolyether group-containing compound, the number average molecular weight of the R^{F1} and R^{F2} moieties is not limited, and is, for example, 500 to 30,000, preferably 1,500 to 30,000, and more preferably 2,000 to 10,000. Herein, the number average molecular weight of R^{F1} and R^{F2} is defined as a value obtained by ¹⁹F-NMR measurement.

In another embodiment, the number average molecular weight of the R^{F1} and R^{F2} moieties may be 500 to 30,000, preferably 1,000 to 20,000, more preferably 2,000 to 15,000, and further preferably 2,000 to 10,000, for example, 3,000 to 6,000.

In another embodiment, the number average molecular weight of the R^{F1} and R^{F2} moieties may be 4,000 to 30,000, preferably 5,000 to 10,000, and more preferably 6,000 to 10,000.

In the formulas (1) and (2), R^{Si} is each independently at each occurrence a monovalent group containing a Si atom to which a hydroxyl group, a hydrolyzable group, a hydrogen atom or a monovalent organic group is bonded, and at least one R^{Si} is a monovalent group containing a Si atom to which a hydroxyl group or a hydrolyzable group is bonded.

Here, the "hydrolyzable group" refers to a group which can undergo a hydrolysis reaction, namely, means a group which can be removed from a main backbone of the compound by a hydrolysis reaction. Examples of the hydrolyzable group include -OR^{h}, -OCOR^{h}, -O-N=CR^{h}₂, -NR^{h}₂, -NHR^{h}, and halogen (in these formulas, R^{h} represents a substituted or unsubstituted C₁₋₄ alkyl group).

In a preferable embodiment, R^{Si} is a monovalent group containing a Si atom to which a hydroxyl group or a hydrolyzable group is bonded.

In a preferable embodiment, R^{Si} is a group represented by the following formula (S1), (S2), (S3), or (S4):

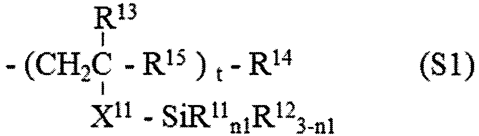

- **SiR¹¹ₙ₁R¹²₃₋ₙ₁** **(S2)**

- **SiR^{a1}ₖ₁R^{b1}₁₁R^{c1}ₘ₁** **(S3)**

**- CR^{d1}ₖ₂R^{e1}₁₂R^{f1}ₘ₂** **(S4)**

In the formulas, R¹¹ is each independently at each occurrence a hydroxyl group or a hydrolyzable group.

R¹¹ is preferably, each independently at each occurrence, a hydrolyzable group.

R¹¹ is preferably, each independently at each occurrence, -OR^{h}, -OCOR^{h}, -O-N=CR^{h}₂, -NR^{h}₂, -NHR^{h}, or halogen, wherein R^{h} represents a substituted or unsubstituted C₁₋₄ alkyl group, and more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formulas, R¹² is each independently at each occurrence a hydrogen atom or a monovalent organic group. Such a monovalent organic group is a monovalent organic group excluding the hydrolyzable group.

In R¹², the monovalent organic group is preferably a C₁₋₂₀ alkyl group, more preferably a C₁₋₆ alkyl group, and still more preferably a methyl group.

In the formulas, n1 is an integer of 0 to 3 each independently in each (SiR¹¹ₙ₁R¹²₃₋ₙ₁) unit. However, in a case where R^{Si} is a group represented by the formula (S1) or (S2), at least one (SiR¹¹ₙ₁R¹²₃₋ₙ₁) unit in which n1 is 1 to 3 is present in the terminal R^{Si} moieties of the formula (1) and the formula (2) (hereinafter, also simply referred to as "terminal moieties" of the formula (1) and the formula (2)). That is, in such terminal moieties, not all n1 are 0 at the same time. In other words, in the terminal moieties of the formula (1) and the formula (2), at least one Si atom to which the hydroxyl group or the hydrolyzable group is bonded is present.

n1 is preferably an integer of 1 to 3, more preferably 2 to 3, and still more preferably 3, each independently in each (SiR¹¹ₙ₁R¹²₃₋ₙ₁) unit.

In the formulas, X¹¹ is each independently at each occurrence a single bond or a divalent organic group. Such a divalent organic group is preferably -R²⁸-Oₓ-R²⁹- (wherein R²⁸ and R²⁹ are each independently at each occurrence a single bond or C₁₋₂₀ alkylene group and x is 0 or 1). Such a C₁₋₂₀ alkylene group may be linear or branched, and is preferably linear. Such a C₁₋₂₀ alkylene group is preferably a C₁₋₁₀ alkylene group, more preferably a C₁₋₆ alkylene group, and still more preferably a C₁₋₃ alkylene group.

In one embodiment, X¹¹ is each independently at each occurrence -C₁₋₆ alkylene-O-C₁₋₆ alkylene- or -O-C₁₋₆ alkylene-.

In a preferable embodiment, X¹¹ is each independently at each occurrence a single bond or a linear C₁₋₆ alkylene group, preferably a single bond or a linear C₁₋₃ alkylene group, more preferably a single bond or a linear C₁₋₂ alkylene group, and still more preferably a linear C₁₋₂ alkylene group.

In the formula, R¹³ is each independently at each occurrence a hydrogen atom or a monovalent organic group. Such a monovalent organic group is preferably a C₁₋₂₀ alkyl group. Such a C₁₋₂₀ alkyl group may be linear or branched, and is preferably linear.

In a preferable embodiment, R¹³ is each independently at each occurrence hydrogen or a linear C₁₋₆ alkyl group, preferably a hydrogen atom or a linear C₁₋₃ alkyl group, and preferably a hydrogen atom or a methyl group.

In the formula, t is each independently at each occurrence an integer of 2 or more.

In a preferable embodiment, t is each independently at each occurrence an integer of 2 to 10, and is preferably an integer of 2 to 6.

In the formula, R¹⁴ is each independently at each occurrence a hydrogen atom, a halogen atom, or -X¹¹-SiR¹¹ₙ₁R¹²₃₋ₙ₁. Such a halogen atom is preferably an iodine atom, a chlorine atom, or a fluorine atom, and more preferably a fluorine atom. In a preferable embodiment, R¹⁴ is a hydrogen atom.

In the formula, R¹⁵ is each independently at each occurrence a single bond, an oxygen atom, an alkylene group having 1 to 6 carbon atoms or an alkyleneoxy group having 1 to 6 carbon atoms.

In one embodiment, R¹⁵ is each independently at each occurrence an oxygen atom, an alkylene group having 1 to 6 carbon atoms or an alkyleneoxy group having 1 to 6 carbon atoms.

In a preferable embodiment, R¹⁵ is a single bond.

In one embodiment, the formula (S1) is the following formula (S1-a): 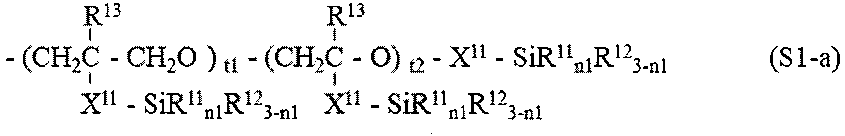 wherein
R¹¹, R¹², R¹³, X¹¹, and n1 have the same definition as described in the formula (S1);
t1 and t2 are each independently at each occurrence an integer of 1 or more, preferably an integer of 1 to 10, more preferably an integer of 2 to 10, for example an integer of 1 to 5 or an integer of 2 to 5; and

The occurrence order of the respective repeating units enclosed in parentheses provided with a subscript t1 and t2 is not limited in the formula.

In a preferable embodiment, the formula (S1) is the following formula (S1-b): 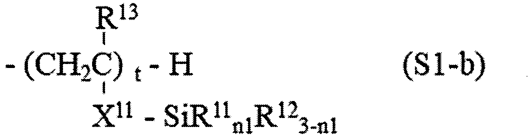 wherein R¹¹, R¹², R¹³, X¹¹, n1, and t have the same definition as described in the formula (S1).

In the formulas, R^{a1} is each independently at each occurrence -Z¹-SiR²¹ₚ₁R²²_{q1}R²³ᵣ₁.

Z¹ is each independently at each occurrence an oxygen atom or a divalent organic group. The right side of the structure denoted as Z¹ below binds to (SiR²¹ₚ₁R²²_{q1}R²³ᵣ₁).

In a preferable embodiment, Z¹ is a divalent organic group.

In a preferable embodiment, Z¹ does not contain a siloxane bond with the silicon atom to which the Z¹ binds. Preferably, in the formula (S3), (Si-Z¹-Si) does not contain a siloxane bond.

Z¹ is preferably a C₁₋₆ alkylene group, - (CH₂)_{z1}-O-(CH₂)_{z2}- (wherein z1 is an integer of 0 to 6; for example, an integer of 1 to 6, and z2 is an integer of 0 to 6; for example, an integer of 1 to 6) or, -(CH₂)_{z3}-phenylene-(CH₂)_{z4}- (wherein z3 is an integer of 0 to 6; for example, an integer of 1 to 6, and z4 is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z¹ is a C₁₋₆ alkylene group or - (CH₂)_{z3}-phenylene- (CH₂)_{z4}-, and preferably -phenylene-(CH₂)_{z4}-. When Z¹ is such a group, light resistance, in particular ultraviolet resistance, can be more increased.

In another preferable embodiment, Z¹ is a C₁₋₃ alkylene group. In one embodiment, Z¹ may be -CH₂CH₂CH₂-. In another embodiment, Z¹ may be -CH₂CH₂-.

R²¹ is each independently at each occurrence -Z^{1'}-SiR^{21'}_{p1'}R^{22'}_{q1'}R^{23'}_{r1'}.

Z^{1'} is each independently at each occurrence an oxygen atom or a divalent organic group. The right side of the structure denoted as Z^{1'} below binds to (SiR^{21'}_{q1'}R^{22'}_{q1'}R^{23'}_{r1'}).

In a preferable embodiment, Z^{1'} is a divalent organic group.

In a preferable embodiment, Z^{1'} does not contain a siloxane bond with the silicon atom to which the Z^{1'} binds. Preferably, in the formula (S3), (Si-Z^{1'}-Si) does not contain a siloxane bond.

Z^{1'} is preferably a C₁₋₆ alkylene group, - (CH₂)_{z1'}-O-(CH₂)_{z2'}- (wherein z1' is an integer of 0 to 6; for example, an integer of 1 to 6, and z2' is an integer of 0 to 6; for example, an integer of 1 to 6) or, -(CH₂)_{z3'}-phenylene-(CH₂)_{z4'}- (wherein z3' is an integer of 0 to 6; for example, an integer of 1 to 6, and z4' is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z^{1'} is a C₁₋₆ alkylene group or - (CH₂)_{z3'}-phenylene- (CH₂)_{z4'}-, and preferably - phenylene- (CH₂)_{z4'}-. When Z^{1'} is such a group, light resistance, in particular ultraviolet resistance, can be more increased.

In another preferable embodiment, Z^{1'} is a C₁₋₃ alkylene group. In one embodiment, Z^{1'} may be -CH₂CH₂CH₂-. In another embodiment, Z^{1'} may be -CH₂CH₂-.

R^{21'} is each independently at each occurrence -Z^{1"}-SiR^{22"}_{q1"}R^{23"}_{r1"} .

Z^{1"} is each independently at each occurrence an oxygen atom or a divalent organic group. The right side of the structure denoted as Z^{1"} below binds to (SiR^{22"}_{qi"}R^{23"}_{r1"}).

In a preferable embodiment, Z^{1"} is a divalent organic group.

In a preferable embodiment, Z^{1"} does not contain a siloxane bond with the silicon atom to which the Z^{1"} binds. Preferably, in the formula (S3), (Si-Z^{1"}-Si) does not contain a siloxane bond.

Z^{1"} is preferably a C₁₋₆ alkylene group, -(CH₂)_{z1"}-O-(CH₂)_{z2"}- (wherein z1" is an integer of 0 to 6; for example, an integer of 1 to 6, and z2" is an integer of 0 to 6; for example, an integer of 1 to 6) or, - (CH₂)_{z3"}-phenylene-(CH₂)_{z4"}- (wherein z3" is an integer of 0 to 6; for example, an integer of 1 to 6, and z4" is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z^{1"} is a C₁₋₆ alkylene group or - (CH₂)_{z3"}-phenylene- (CH₂)_{z4"}-, and preferably - phenylene- (CH₂)'_{z4"}-. When Z^{1"} is such a group, light resistance, in particular ultraviolet resistance, can be more increased.

In another preferable embodiment, Z^{1"} is a C₁₋₃ alkylene group. In one embodiment, Z^{1"} may be -CH₂CH₂CH₂-. In another embodiment, Z^{1"} may be -CH₂CH₂-.

R^{22"} is each independently at each occurrence a hydroxyl group or a hydrolyzable group.

R²² is preferably, each independently at each occurrence, a hydrolyzable group.

R^{22"} is preferably, each independently at each occurrence, -OR^{h}, -OCOR^{h}, -O-N=CR^{h}₂, -NR^{h}₂, -NHR^{h}, or halogen, wherein R^{h} represents a substituted or unsubstituted C₁₋₄ alkyl group, more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23"} is each independently at each occurrence a hydrogen atom or a monovalent organic group. Such a monovalent organic group is a monovalent organic group excluding the hydrolyzable group.

In R^{23"}, the monovalent organic group is preferably a C₁₋₂₀ alkyl group, more preferably a C₁₋₆ alkyl group, and still more preferably a methyl group.

q1" is each independently at each occurrence an integer of 0 to 3, and r1" is each independently at each occurrence an integer of 0 to 3. The total of q1" and r1" is 3 in (SiR^{22"}_{qi"}R^{23"}_{r1"})unit.

q1" is preferably an integer of 1 to 3, more preferably 2 to 3, and further preferably 3, each independently in each (SiR^{22"}_{qi"}R^{23"}_{r1"})unit.

R^{22'} is each independently at each occurrence a hydroxyl group or a hydrolyzable group.

R^{22'} is preferably, each independently at each occurrence, a hydrolyzable group.

R^{22'} is preferably, each independently at each occurrence, -OR^{h}, -OCOR^{h}, -O-N=CR^{h}₂, -NR^{h}₂, -NHR^{h}, or halogen, wherein R^{h} represents a substituted or unsubstituted C₁₋₄ alkyl group, more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23'} is each independently at each occurrence a hydrogen atom or a monovalent organic group. Such a monovalent organic group is a monovalent organic group excluding the hydrolyzable group.

In R^{23'}, the monovalent organic group is preferably a C₁₋₂₀ alkyl group, more preferably a C₁₋₆ alkyl group, and still more preferably a methyl group.

p1' is each independently at each occurrence an integer 0 to 3, q1' is each independently at each occurrence an integer of 0 to 3, and r1' is each independently at each occurrence an integer of 0 to 3. The total of p', q1' and r1' is 3 in (SiR^{21'}_{p1'}R^{22'}_{q1'}R^{23'}_{r1'}) unit.

In one embodiment, p1' is 0.

In one embodiment, p1' may be an integer of 1 to 3, an integer of 2 to 3, or 3, each independently in each (SiR^{21'}_{p1'}R^{22'}_{q1'}R^{23'}_{r1'}) unit. In a preferable embodiment, p1' is 3.

In one embodiment, q1' is an integer of 1 to 3, preferably 2 to 3, and more preferably 3, each independently in each (SiR^{21'}_{p1'}R^{22'}_{q1'}R^{23'}_{r1'}) unit.

In one embodiment, p1' is 0, q1' is an integer of 1 to 3, preferably 2 to 3, and still more preferably 3, each independently in each (SiR^{21'}_{p1'}R^{22'}_{q1'}R^{23'}_{r1'}) unit.

R²² is each independently at each occurrence a hydroxyl group or a hydrolyzable group.

R²² is preferably, each independently at each occurrence, a hydrolyzable group.

R²² is preferably, each independently at each occurrence, -OR^{h}, -OCOR^{h}, -O-N=CR^{h}₂, -NR^{h}₂, -NHR^{h}, or halogen, wherein R^{h} represents a substituted or unsubstituted C₁₋₄ alkyl group, more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R²³ is each independently at each occurrence a hydrogen atom or a monovalent organic group. Such a monovalent organic group is a monovalent organic group excluding the hydrolyzable group.

In R²³, the monovalent organic group is preferably a C₁₋₂₀ alkyl group, more preferably a C₁₋₆ alkyl group, and still more preferably a methyl group.

p1 is each independently at each occurrence an integer of 0 to 3, q1 is each independently at each occurrence an integer of 0 to 3, and r1 is each independently at each occurrence 0 to 3. The total of p1, q1 and r1 is 3 in (SiR²¹ₚ₁R²²_{q1}R²³ᵣ₁) unit.

In one embodiment, p1 is 0.

In one embodiment, p1 may be an integer of 1 to 3, an integer of 2 to 3, or 3, each independently in each (SiR²¹ₚ₁R²²_{q1}R²³ᵣ₁) unit. In a preferable embodiment, p1 is 3.

In one embodiment, q1 is an integer of 1 to 3, preferably 2 to 3, and more preferably 3, each independently in each (SiR²¹ₚ₁R²²_{q1}R²³ᵣ₁) unit.

In one embodiment, p1 is 0, q1 is an integer of 1 to 3, preferably 2 to 3, and still more preferably 3, each independently in each (SiR²¹ₚ₁R²²_{q1}R²³ᵣ₁) unit.

In the formulas, R^{b1} is each independently at each occurrence a hydroxyl group or a hydrolyzable group.

R^{b1} is preferably, each independently at each occurrence, a hydrolyzable group.

R^{b1} is preferably, each independently at each occurrence, -OR^{h}, -OCOR^{h}, -O-N=CR^{h}₂, -NR^{h}₂, -NHR^{h}, or halogen, wherein R^{h} represents a substituted or unsubstituted C₁₋₄ alkyl group, more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formula, R^{c1} is each independently at each occurrence a hydrogen atom or a monovalent organic group. Such a monovalent organic group is a monovalent organic group excluding the hydrolyzable group.

In R^{c1}, the monovalent organic group is preferably a C₁₋₂₀ alkyl group, more preferably a C₁₋₆ alkyl group, and still more preferably a methyl group.

k1 is each independently at each occurrence an integer of 0 to 3, 11 is each independently at each occurrence an integer of 0 to 3, and m1 is each independently at each occurrence an integer of 0 to 3. The total of k1, 11 and m1 is 3 in (SiR^{a1}ₖ₁R^{b1}ₗ₁R^{C1}ₘ₁) unit.

In one embodiment, k1 is an integer of 1 to 3, preferably 2 to 3, and more preferably 3, each independently in each (SiR^{a1}ₖ₁R^{b1}ₗ₁^{c1}ₘ₁) unit. In a preferable embodiment, k1 is 3.

In the formulae (1) and (2), when R^{Si} is a group represented by the formula (S3), preferably, at least two Si atoms to which a hydroxyl group or a hydrolyzable group is bonded are present in the terminal moieties of the formulae (1) and (2).

In a preferable embodiment, the group represented by formula (S3) has any one of -Z¹-SiR²²_{q1}R²³ᵣ₁ (wherein q1 is an integer of 1 to 3, preferably 2 or 3, more preferably 3, and r1 is an integer of 0 to 2.), -Z^{1'}-SiR^{22'}_{q1'}R^{23'}_{r1'} (wherein q1' is an integer of 1 to 3, preferably 2 or 3, more preferably 3, and r1' is an integer of 0 to 2), or - Z^{1"}-SiR^{22"}_{q1"}R^{23"}ᵣ₁" (wherein q1" is an integer of 1 to 3, preferably 2 or 3, more preferably 3, and r1" is an integer of 0 to 2). Z¹, Z^{1'}, Z^{1"}, R²², R²³, R^{22'}, R^{23'}, R^{22"}, and R^{23"} have the same definition as above.

In a preferable embodiment, in the formula (S3), when R^{21'} is present, in at least one, preferably all R^{21'}, q1" is an integer of 1 to 3, preferably 2 or 3, more preferably 3.

In a preferable embodiment, in the formula (S3), when R²¹ is present, in at least one, preferably all R²¹, p1' is 0, and q1' is an integer of 1 to 3, preferably 2 or 3, more preferably 3.

In a preferable embodiment, in the formula (S3), when R^{a1} is present, in at least one, preferably all R^{a1}, p1 is 0, and q1 is an integer of 1 to 3, preferably 2 or 3, more preferably 3.

In a preferable embodiment, in the formula (S3), k1 is 2 or 3, preferably 3, p1 is 0, q1 is 2 or 3, preferably 3.

R^{d1} is each independently at each occurrence -Z²-CR³¹ₚ₂R³²_{q2}R³³ᵣ₂.

Z² is each independently at each occurrence a single bond, an oxygen atom or a divalent organic group. The right side of the structure denoted as Z² below binds to (CR³¹ₚ₂R³²_{q2}R³³ᵣ₂) .

In a preferable embodiment, Z² is a divalent organic group.

Z² is preferably a C₁₋₆ alkylene group, -(CH₂)_{z5}-O-(CH₂)_{z6}- (wherein z5 is an integer of 0 to 6; for example, an integer of 1 to 6, and z6 is an integer of 0 to 6; for example, an integer of 1 to 6) or, -(CH₂)_{z7}-phenylene-(CH₂)_{z8}- (wherein z7 is an integer of 0 to 6; for example, an integer of 1 to 6, and z8 is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z² is a C₁₋₆ alkylene group or - (CH₂)_{z7}-phenylene- (CH₂)_{z8}-, and preferably -phenylene-(CH₂)_{z8}-. When Z² is such a group, light resistance, in particular ultraviolet resistance, can be more increased.

In another preferable embodiment, Z² is a C₁₋₃ alkylene group. In one embodiment, Z² may be -CH₂CH₂CH₂-. In another embodiment, Z² may be -CH₂CH₂-.

R³¹ is each independently at each occurrence -Z^{2'}-CR^{32'}_{q2'}R^{33'}_{r2'} .

Z^{2'} is each independently at each occurrence a single bond, an oxygen atom or a divalent organic group. The right side of the structure denoted as Z^{2'} below binds to (CR^{32'}_{q2'}R^{33'}_{r2'}).

Z^{2'} is preferably a C₁₋₆ alkylene group, -(CH₂)_{z1'}-O-(CH₂)_{z6'}- (wherein z5' is an integer of 0 to 6; for example, an integer of 1 to 6, and z6' is an integer of 0 to 6; for example, an integer of 1 to 6) or, -(CH₂)_{z7'}-phenylene-(CH₂)_{z8'}- (wherein z7' is an integer of 0 to 6; for example, an integer of 1 to 6, and z8' is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z^{2'} is a C₁₋₆ alkylene group or - (CH₂)_{z7'}-phenylene- (CH₂)_{z8'}-, and preferably - phenylene- (CH₂)_{z8'}-. When Z^{2'} is such a group, light resistance, in particular ultraviolet resistance, can be more increased.

In another preferable embodiment, Z^{2'} is a C₁₋₃ alkylene group. In one embodiment, Z^{2'} may be -CH₂CH₂CH₂-. In another embodiment, Z^{2'} may be -CH₂CH₂-.

R^{32'} is each independently at each occurrence -Z³-. SiR³⁴ₙ₂R³⁵₃₋ₙ₂ .

Z³ is each independently at each occurrence a single bond, an oxygen atom or a divalent organic group. The right side of the structure denoted as Z³ below binds to (SiR³⁴ₙ₂R³⁵₃₋ₙ₂).

In one embodiment, Z³ is an oxygen atom.

In one embodiment, Z³ is a divalent organic group.

Z³ is preferably a C₁₋₆ alkylene group, -(CH₂)_{z5"}-O-(CH₂)_{z6"}— (wherein z5" is an integer of 0 to 6; for example, an integer of 1 to 6, and z6" is an integer of 0 to 6; for example, an integer of 1 to 6) or, - (CH₂)_{z7"}-phenylene-(CH₂)_{z8"}- (wherein z7" is an integer of 0 to 6; for example, an integer of 1 to 6, and z8" is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferable embodiment, Z³ is a C₁₋₆ alkylene group or - (CH₂)_{z7"}-phenylene-(CH₂)_{z8"}-, and preferably -phenylene-(CH₂)_{z8"}-. When Z³ is such a group, light resistance, in particular ultraviolet resistance, can be more increased.

In another preferable embodiment, Z³ is a C₁₋₃ alkylene group. In one embodiment, Z³ may be -CH₂CH₂CH₂-. In another embodiment, Z³ may be -CH₂CH₂-.

R³⁴ is each independently at each occurrence a hydroxyl group or a hydrolyzable group.

R³⁴ is preferably, each independently at each occurrence, a hydrolyzable group.

R³⁴ is, each independently at each occurrence, preferably -OR^{h}, -OCOR^{h}, -O-N=CR^{h}₂, -NR^{h}₂, - NHR^{h}, or halogen (in these formulas, R^{h} represents a substituted or unsubstituted C₁₋₄ alkyl group), and more preferably -OR^{h} (that is, an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R³⁵ is each independently at each occurrence a hydrogen atom or a monovalent organic group. Such a monovalent organic group is a monovalent organic group excluding the hydrolyzable group.

In R³⁵, the monovalent organic group is preferably a C₁₋₂₀ alkyl group, more preferably a C₁₋₆ alkyl group, and still more preferably a methyl group.

In the formula, n2 is an integer of 0 to 3 each independently in each (SiR³⁴ₙ₂R³⁵₃₋ₙ₂) unit. However, in a case where R^{si} is a group represented by the formula (S4), at least one (SiR³⁴ₙ₂R³⁵₃₋ₙ₂) unit in which n2 is 1 to 3 is present in the terminal moieties of the formula (1) and the formula (2). That is, in such terminal moieties, not all n2 are 0 at the same time. In other words, in the terminal moieties of the formula (1) and the formula (2), at least one Si atom to which the hydroxyl group or the hydrolyzable group is bonded is present.

n2 is preferably an integer of 1 to 3, more preferably 2 to 3, and still more preferably 3, each independently in each (SiR³⁴ₙ₂R³⁵₃₋ₙ₂) unit.

R^{33'} is each independently at each occurrence a hydrogen atom, a hydroxyl group, or a monovalent organic group. Such a monovalent organic group is a monovalent organic group excluding the hydrolyzable group.

In R^{33'}, the monovalent organic group is preferably a C₁₋₂₀ alkyl group or- (CₛH₂ₛ)ₜ₁-(O-CₛH₂ₛ)ₜ₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, still more preferably a C₁₋₆ alkyl group, particularly preferably a methyl group.

In one embodiment, R^{33'} is a hydroxyl group.

In another embodiment, in R^{33'}, the monovalent organic group is preferably a C₁₋₂₀ alkyl group, and more preferably a C₁₋₆ alkyl group.

q2' is each independently at each occurrence an integer of 0 to 3, and r2' is each independently at each occurrence an integer of 0 to 3. The sum of q2' and r2' is 3 in the (CR^{32'}_{q2'}R^{33'}_{r2'}) unit.

q2' is preferably an integer of 1 to 3, more preferably 2 to 3, and still more preferably 3, each independently in each (CR^{32'}_{q2'}R^{33'}_{r2'}) unit.

R³² is each independently at each occurrence -Z³-SiR³⁴ₙ₂R³⁵₃₋ₙ₂. Such -Z³-SiR³⁴ₙ₂R³⁵₃₋ₙ₂ has the same definition as described in R^{32'}.

R³³ is each independently at each occurrence a hydrogen atom, a hydroxyl group, or a monovalent organic group. Such a monovalent organic group is a monovalent organic group excluding the hydrolyzable group.

In R³³, the monovalent organic group is preferably a C₁₋₂₀ alkyl group or- (CₛH₂ₛ)ₜ₁-(O-CₛH₂ₛ)ₜ₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, still more preferably a C₁₋₆ alkyl group, particularly preferably a methyl group.

In one embodiment, R³³ is a hydroxyl group.

In another embodiment, in R³³, the monovalent organic group is preferably a C₁₋₂₀ alkyl group, and more preferably a C₁₋₆ alkyl group.

p2 is each independently at each occurrence an integer of 0 to 3, q2 is each independently at each occurrence an integer of 0 to 3, and r2 is each independently at each occurrence an integer of 0 to 3. The total of p2, q2, and r2 is 3 in (CR³¹ₚ₂R³²_{q2}R³³ᵣ₂) unit.

In one embodiment, p2 is 0.

In one embodiment, p2 may be an integer of 1 to 3, an integer of 2 to 3, or 3, each independently in each (CR³¹ₚ₂R³²_{q2}R³³ᵣ₂) unit. In a preferable embodiment, p2 is 3.

In one embodiment, q2 is an integer of 1 to 3, preferably 2 to 3, and more preferably 3, each independently in each (CR³¹ₚ₂R³²_{q2}R³³ᵣ₂) unit.

In one embodiment, p2 is 0, q2 is an integer of 1 to 3, preferably 2 to 3, and still more preferably 3, each independently in each (CR³¹ₚ₂R³²_{q2}R³³ᵣ₂) unit.

R^{e1} is each independently at each occurrence -Z³-SiR³⁴ₙ₂R³⁵₃₋ₙ₂. Such -Z³-SiR³⁴ₙ₂R³⁵₃₋ₙ₂ has the same definition as described in R^{32'}.

R^{f1} is each independently at each occurrence a hydrogen atom, a hydroxyl group, or a monovalent organic group. Such a monovalent organic group is a monovalent organic group excluding the hydrolyzable group.

In R^{f1}, the monovalent organic group is preferably a C₁₋₂₀ alkyl group or- (CₛH₂ₛ)ₜ₁-(O-CₛH₂ₛ)ₜ₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, still more preferably a C₁₋₆ alkyl group, particularly preferably a methyl group.

In one embodiment, R^{f1} is a hydroxyl group.

In another embodiment, in R^{f1}, the monovalent organic group is preferably a C₁₋₂₀ alkyl group, and more preferably a C₁₋₆ alkyl group.

k2 is each independently at each occurrence an integer of 0 to 3, 12 is each independently at each occurrence an integer of 0 to 3, and m2 is each independently at each occurrence an integer of 0 to 3. The total of k2, 12, and m2 is 3 in (CR^{d1}ₖ₂R^{e1}₁₂R^{f1}ₘ₂) unit.

In one embodiment, when R^{si} is a group represented by the formula (S4), two or more, for example, 2 to 27, preferably 2 to 9, more preferably 2 to 6, still more preferably 2 to 3, particularly preferably 3 (SiR³⁴ₙ₂R³⁵₃₋ₙ₂) units in which n2 is 1 to 3, preferably 2 or 3, more preferably 3 are present in each terminal moiety of the formula (1) and the formula (2).

In a preferable embodiment, in the formula (S4), when R^{32'} is present, in at least one, preferably all R^{32'}, n2 is an integer of 1 to 3, preferably 2 or 3, more preferably 3.

In a preferable embodiment, in the formula (S4), when R³² is present, in at least one, preferably all R³², n2 is an integer of 1 to 3, preferably 2 or 3, more preferably 3.

In a preferable embodiment, in the formula (S4), when R^{e1} is present, in at least one, preferably all R^{a1}, n2 is an integer of 1 to 3, preferably 2 or 3, more preferably 3.

In a preferable embodiment, in the formula (S4), k2 is 0, 12 is 2 or 3, preferably 3, and n2 is 2 or 3, preferably 3.

In one embodiment, R^{si} is a group represented by the formula (S2), (S3) or (S4). These compounds can form a surface-treating layer having high surface lubricity.

In one embodiment, R^{si} is a group represented by the formula (S1), (S3) or (S4). These compounds have a plurality of hydrolyzable groups at one end, and thus can form a surface-treating layer that strongly adheres to a substrate and has high friction durability.

In one embodiment, R^{si} is a group represented by the formula (S3) or (S4). These compounds can have a plurality of hydrolyzable groups branched from one Si atom or C atom at one end, and a surface-treating layer having higher friction durability can thus be formed.

In one embodiment, R^{Si} is a group represented by the formula (S1).

In one embodiment, R^{si} is a group represented by the formula (S2).

In one embodiment, R^{si} is a group represented by the formula (S3).

In one embodiment, R^{si} is a group represented by the formula (S4).

In the formulas (1) and (2), X^{A} is interpreted as a linker, connecting a fluoropolyether moiety (R^{F1} and R^{F2}) which mainly provides, e.g., water-repellency and surface lubricity, and a moiety (R^{Si}) providing binding ability to a substrate. Accordingly, X^{A} may be a single bond or any group as long as the compound represented by the formula (I) or (2) can stably exist.

In the formula (1), α is an integer of 1 to 9, and β is an integer of 1 to 9. The integers represented by α and β may vary depending on the valence of X^{A}. The sum of α and β is the same as the valence of X^{A}. For example, when X^{A} is a decavalent organic group, the sum of α and β is 10; for example, a case where α is 9 and β is 1, and α is 5 and β is 5, or α is 1 and β is 9, can be considered. When X^{A} is a divalent organic group, α and β each are 1.

In the formula (2), γ is an integer of 1 to 9. γ may vary according to the valence of X^{A}. That is, γ is a value obtained by subtracting 1 from the valence of X^{A}.

X^{A} is each independently a single bond or a di- to decavalent organic group;

The di- to decavalent organic group in X^{A} is preferably a di- to octavalent organic group. In one embodiment, the di- to decavalent organic group is preferably a di- to tetravalent organic group, and more preferably a divalent organic group. In another embodiment, the di- to decavalent organic group is preferably a tri- to octavalent organic group, and more preferably a tri- to hexavalent organic group.

In one embodiment, X^{A} is a single bond or a divalent organic group, α is 1, and β is 1.

In one embodiment, X^{A} is a single bond or a divalent organic group, γ is 1.

In one embodiment, X^{A} is a tri- to hexavalent organic group, α is 1, and β is 2 to 5.

In one embodiment, X^{A} is a tri- to hexavalent organic group, and γ is 2 to 5.

In one embodiment, X^{A} is a trivalent organic group, α is 1, and β is 2.

In one embodiment, X^{A} is a trivalent organic group, and γ is 2.

When X^{A} is a single bond or a divalent organic group, the formulas (1) and (2) are represented by the following formulas (1') and (2').

R^{F1} - X^{A} - R^{Si} (1')

R^{Si} - X^{A} - R^{F2} - X^{A} - R^{Si} (2')

In one embodiment, X^{A} is a single bond.

In another embodiment, X^{A} is a divalent organic group.

In one embodiment, examples of X^{A} include a single bond or a divalent organic group represented by the following formula:

- (R⁵¹)ₚ₅-(X⁵¹)_{q5}-

wherein
R⁵¹ represents a single bond, - (CH₂)ₛ₅-, an o-, m-, or p-phenylene group, and is preferably -(CH₂)ₛ₅-;
s5 is an integer of 1 to 20, preferably 1 to 6, more preferably 1 to 3 and further preferably 1 or 2;
X⁵¹ represents - (X⁵²)₁₅-;
X⁵² each independently at each occurrence represents a group selected from the group consisting of -O-, -S-, an o-, m-, or p-phenylene group, -C(O)O-, -Si(R⁵³)₂-, - (Si(R⁵³)₂O)ₘ₅-Si(R⁵³)₂-, -CONR⁵⁴-, -O-CONR⁵⁴-, -NR⁵⁴- and - (CH₂)ₙ₅-;
R⁵³ each independently at each occurrence represents a phenyl group, a C₁₋₆ alkyl group or a C₁₋₆ alkoxy group, and is preferably a phenyl group or a C₁₋₆ alkyl group, and more preferably a methyl group;
R⁵⁴ each independently at each occurrence represents a hydrogen atom, a phenyl group or a C₁₋₆ alkyl group (preferably a methyl group);
m5 is each independently at each occurrence an integer of 1 to 100 and preferably an integer of 1 to 20;
n5 is each independently at each occurrence an integer of 1 to 20, preferably an integer of 1 to 6, and more preferably an integer of 1 to 3;
15 is an integer of 1 to 10, preferably an integer of 1 to 5, and more preferably an integer of 1 to 3;
p5 is 0 or 1; and
q5 is 0 or 1;
provided that at least one of p5 and q5 is 1 and the occurrence order of the respective repeating units enclosed in parentheses provided with p5 or q5 is not limited. Here, X^{A} (typically, hydrogen atoms of X^{A}) is optionally substituted with one or more substituents selected from a fluorine atom, a C₁₋₃ alkyl group, and a C₁₋₃ fluoroalkyl group. In a preferable embodiment, X^{A} is not substituted with these groups.

In a preferable embodiment, X^{A} is each independently - (R⁵¹)ₚ₅-(X⁵¹)_{q5}-R⁵²-. R⁵² represents a single bond, -(CH₂)ₜ₅-, an o-, m-, or a p-phenylene group, and is preferably - (CH₂)ₜ₅-. t5 is an integer of 1 to 20, preferably an integer of 2 to 6, and more preferably an integer of 2 to 3. Here, R⁵² (typically, hydrogen atoms of R⁵²) is optionally substituted with one or more substituents selected from a fluorine atom, a C₁₋₃ alkyl group, and a C₁₋₃ fluoroalkyl group. In a preferable embodiment, R⁵⁶ is not substituted with these groups.

Preferably, X^{A} may each independently be
a single bond,
a C₁₋₂₀ alkylene group,
-R⁵¹-X⁵³-R⁵²-, or
-X⁵⁴-R⁵-
wherein R⁵¹ and R⁵² have the same definition as above; and X⁵³ represents
-O-,
-S-,
-C(O)O-,
-CONR⁵⁴-,
-O-CONR⁵⁴-,
-Si(R⁵³)₂-,
-(Si(R⁵³)₂O)ₘ₅-Si(R⁵³)₂-,
-O-(CH₂)ᵤ₅-(Si (R⁵³)₂O)ₘ₅-Si(R⁵³)₂-,
-O-(CH₂)ᵤ₅-Si(R⁵³)₂-O-Si(R⁵³)₂-CH₂CH₂-Si(R⁵³)₂-O-Si(R⁵³)₂-,
-O-(CH₂)ᵤ₅-Si(OCH₃)₂OSi(OCH₃)₂-,
-CONR⁵⁴-(CH₂)ᵤ₅-(Si (R⁵³)₂O)ₘ₅-Si(R⁵³)₂-,
-CONR⁵⁴-(CH₂)ᵤ₅-N (R⁵⁴)-, or
-CONR⁵⁴-(o-, m- or p-phenylene) -Si (R⁵³)₂-
(wherein R⁵³, R⁵⁴, and m5 have the same definition as above, and
   u5 is an integer of 1 to 20, preferably an integer of 2 to 6, and more preferably an integer of 2 to 3); and
   X⁵⁴ represents
-S-,
-C(O)O-,
-CONR⁵⁴-,
-O-CONR⁵⁴-,
-CONR⁵⁴-(CH₂)ᵤ₅-(Si(R⁵⁴)₂O)ₘ₅-Si(R⁵⁴)₂-,
-CONR⁵⁴-(CH₂)ᵤ₅-N(R⁵⁴)-, or
-CONR⁵⁴-(o-, m- or p-phenylene) -Si (R⁵⁴)₂-
(wherein each symbol has the same definition as above).

More preferably, X^{A} each independently is
a single bond,
a C₁₋₂₀ alkylene group,
- (CH₂)ₛ₅X⁵³-,
-(CH₂)ₛ₅-X⁵³(CH₂)ₜ₅-,
-X⁵⁴-, or
-X⁵⁴-(CH₂)ₜ₅-,
wherein X⁵³, X⁵⁴, s5, and t5 have the same definition as above.

More preferably, X^{A} may each independently be
a single bond,
a C₁₋₂₀ alkylene group,
- (CH₂)ₛ₅-X⁵³-(CH₂)ₜ₅-, or
-X⁵⁴-(CH₂)ₜ₅-,
wherein each symbol has the same definition as above.

In a preferable embodiment, X^{A} may each independently be
a single bond,
a C₁₋₂₀ alkylene group,
- (CH₂)ₛ₅-X⁵³-, or
- (CH₂)ₛ₅-X⁵³-(CH₂)ₜ₅-,
wherein
   X⁵³ is -O-, -CONR⁵⁴-, or -O-CONR⁵⁴-;
   R⁵⁴ each independently at each occurrence represents a hydrogen atom, a phenyl group, or a C₁₋₆ alkyl group;
   s5 is an integer of 1 to 20; and
   t5 is an integer of 1 to 20.

In a preferable embodiment, X^{A} may each independently be
- (CH₂)ₛ₅-O-(CH₂)ₜ₅-, or
-CONR⁵⁴-(CH₂)ₜ₅-,
wherein
   R⁵⁴ each independently at each occurrence represents a hydrogen atom, a phenyl group, or a C₁₋₆ alkyl group;
   s5 is an integer of 1 to 20; and
   t5 is an integer of 1 to 20.

In one embodiment, X^{A} each independently is
a single bond,
a C₁₋₂₀ alkylene group,
-(CH₂)ₛ₅-O-(CH₂)ₜ₅-,
- (CH₂)ₛ₅-(Si(R⁵³)₂O)ₘ₅-Si(R⁵³)₂-(CH₂)ₜ₅-,
- (CH₂)ₛ₅-O-(CH₂)ᵤ₅-(Si(R⁵³)₂O)ₘ₅-Si(R⁵³)₂-(CH₂)ₜ₅-, or
- (CH₂)ₛ₅-O-(CH₂)ₜ₅-Si(R⁵³)₂-(CH₂)ᵤ₅-Si(R⁵³)₂-(CᵥH₂ᵥ)-,
wherein R⁵³, m5, s5, t5, and u5 have the same definition as above, and v5 is an integer of 1 to 20, preferably an integer of 2 to 6, and more preferably an integer of 2 to 3.

In the formula, -(CᵥH₂ᵥ)- may be linear or branched and may be, for example, -CH₂CH₂-, -CH₂CH₂CH₂-, -CH(CH₃)-, or - CH(CH₃) CH₂-.

The X^{A} group each independently is optionally substituted with one or more substituents selected from a fluorine atom, a C₁₋₃ alkyl group and a C₁₋₃ fluoroalkyl group (preferably, C₁₋₃ perfluoroalkyl group). In one embodiment, X^{A} is unsubstituted.

The left side of each formula of X^{A} binds to R^{F1} or R^{F2}, and the right side binds to R^{Si}.

In one embodiment, X^{A} may each independently be a group other than an -O-C₁₋₆ alkylene group.

In another embodiment, examples of the X^{A} group include the following groups: 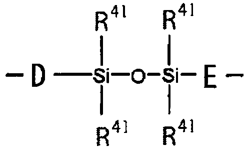 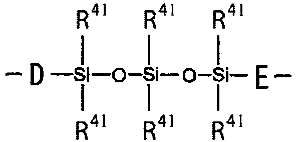 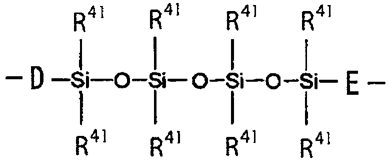 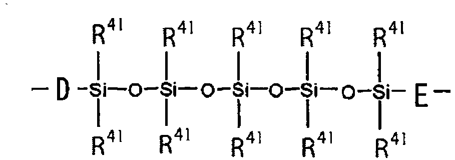 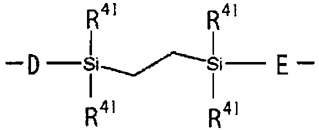 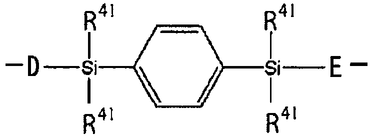 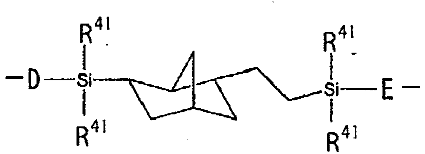 wherein R⁴¹ each independently represents a hydrogen atom, a phenyl group, an alkyl group having 1 to 6 carbon atoms or a C₁₋₆ alkoxy group, and preferably a methyl group; and
D is a group selected from
   - CH₂O(CH₂)₂-,
   - CH₂O(CH₂)₃-,
   - CF₂O(CH₂)₃-,
   - (CH₂)₂-,
   - (CH₂)₃-,
   - (CH₂)₄- ,
   - CONH- (CH₂)₃-,
   - CON(CH₃)-(CH₂)₃-,
   - CON(Ph)-(CH₂)₃- (wherein Ph stands for phenyl), and 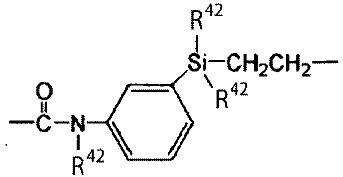 (wherein R⁴² each independently represents a hydrogen atom, a C₁₋₆ alkyl group or a C₁₋₆ alkoxy group, preferably a methyl group or a methoxy group, and more preferably a methyl group),
E is -(CH₂)ₙ- (n is an integer of 2 to 6), and
D binds to R^{F1} or R^{F2} of the molecular backbone and E binds to R^{Si}.

Specific examples of the above-described X^{A} include, for example:
a single bond,
-CH₂OCH₂-,
-CH₂O(CH₂)₂-,
-CH₂O(CH₂)₃-,
-CH₂O(CH₂)₄-,
-CH₂O(CH₂)₅-,
-CH₂O(CH₂)₆-,
-CH₂O(CH₂)₃Si(CH₃)₂OSi(CH₃)₂(CH₂)₂-,
-CH₂O(CH₂)₃Si(CH₃)₂OSi(CH₃)₂OSi(CH₃)₂(CH₂)₂-,
-CH₂O(CH₂)₃Si(CH₃)₂O(Si(CH₃)₂O)₂Si(CH₃)₂(CH₂)₂-,
-CH₂O(CH₂)₃Si(CH₃)₂O(Si(CH₃)₂O)₃Si(CH₃)₂(CH₂)₂-,
-CH₂O(CH₂)₃Si(CH₃)₂O(Si(CH₃)₂O)₁₀Si(CH₃)₂(CH₂)₂-,
-CH₂O(CH₂)₃Si(CH₃)₂O(Si(CH₃)₂O)₂OSi(CH₃)₂(CH₂)₂-,
-CH₂OCF₂CHFOCF₂-,
-CH₂OCF₂CHFOCF₂CF₂-,
-CH₂OCF₂CHFOCF₂CF₂CF₂-,
-CH₂OCH₂CF₂CF₂OCF₂-,
-CH₂OCH₂CF₂CF₂OCF₂CF₂-,
-CH₂OCH₂CF₂CF₂OCF₂CF₂CF₂-,
-CH₂OCH₂CF₂CF₂OCF(CF₃)CF₂OCF₂-,
-CH₂OCH₂CF₂CF₂OCF(CF₃)CF₂OCF₂CF₂-,
-CH₂OCH₂CF₂CF₂OCF(CF₃)CF₂OCF₂CF₂CF₂-,
-CH₂OCH₂CHFCF₂OCF₂-,
-CH₂OCH₂CHFCF₂OCF₂CF₂-,
-CH₂OCH₂CHFCF₂OCF₂CF₂CF₂-,
-CH₂OCH₂CHFCF₂OCF(CF₃)CF₂OCF₂-,
-CH₂OCH₂CHFCF₂OCF(CF₃)CF₂OCF₂CF₂-,
-CH₂OCH₂CHFCF₂OCF(CF₃)CF₂OCF₂CF₂CF₂-
-CH₂OCF₂CHFOCF₂CF₂CF₂-C(O)NH-CH₂-,
CH₂OCH₂(CH₂)₇CH₂Si(OCH₃)₂OSi(OCH₃)₂(CH₂)₂Si(OCH₃)₂OSi(OCH₃)₂(CH₂ )₂-,
-CH₂OCH₂CH₂CH₂Si(OCH₃)₂OSi(OCH₃)₂(CH₂)₃-,
-CH₂OCH₂CH₂CH₂Si(OCH₂CH₃)₂OSi(OCH₂CH₃)₂(CH₂)₃-,
-CH₂OCH₂CH₂CH₂Si(OCH₃)₂OSi(OCH₃)₂(CH₂)₂-,
-CH₂OCH₂CH₂CH₂Si(OCH₂CH₃)₂OSi(OCH₂CH₃)₂(CH₂)₂-,
- (CH₂)₂-Si(CH₃)₂-(CH₂)₂-,
-CH₂-,
- (CH₂)₂-,
- (CH₂)₃-,
- (CH₂)₄-,
-(CH₂)₅-,
- (CH₂)₆-,
-CO-,
-CONH-,
-CONH-CH₂-,
-CONH-(CH₂)₂-,
-CONH-(CH₂)₃-,
-CONH-(CH₂)₄-,
-CONH-(CH₂)₅-,
-CONH-(CH₂)₆-,
-CON(CH₃)-CH₂-,
-CON(CH₃)-(CH₂)₂-,
-CON(CH₃)-(CH₂)₃-,
-CON(CH₃)-(CH₂)₄-,
-CON(CH₃)-(CH₂)₅-,
-CON(CH₃)-(CH₂)₆-,
-CON(Ph)-CH₂- (wherein Ph stands for phenyl),
-CON(Ph)-(CH₂)₂- (wherein Ph stands for phenyl),
-CON(Ph)-(CH₂)₃- (wherein Ph stands for phenyl),
-CON(Ph)-(CH₂)₄- (wherein Ph stands for phenyl),
-CON(Ph)-(CH₂)₅- (wherein Ph stands for phenyl),
-CON(Ph)-(CH₂)₆- (wherein Ph stands for phenyl),
-CONH-(CH₂)₂NH(CH₂)₃-,
-CONH-(CH₂)₆NH(CH₂)₃-,
-CH₂O-CONH-(CH₂)₃-,
-CH₂O-CONH-(CH₂)₆-,
-S-(CH₂)₃-,
- (CH₂)₂S(CH₂)₃-,
-CONH-(CH₂)₃Si(CH₃)₂OSi(CH₃)₂(CH₂)₂-,
-CONH-(CH₂)₃Si(CH₃)₂OSi(CH₃)₂OSi(CH₃)₂(CH₂)₂-,
-CONH-(CH₂)₃Si(CH₃)₂O(Si(CH₃)₂O)₂Si(CH₃)₂(CH₂)₂-,
-CONH-(CH₂)₃Si(CH₃)₂O(Si(CH₃)₂O)₃Si(CH₃)₂(CH₂)₂-,
-CONH-(CH₂)₃Si(CH₃)₂O(Si(CH₃)₂O)₁₀Si(CH₃)₂(CH₂)₂-,
-CONH-(CH₂)₃Si(CH₃)₂O(Si(CH₃)₂O)₂₀Si(CH₃)₂(CH₂)₂-,
-C(O)O-(CH₂)₃-,
-C(O)O-(CH₂)₆-,
-CH₂-O-(CH₂)₃-Si(CH₃)₂-(CH₂)₂-Si(CH₃)₂-(CH₂)₂-,
-CH₂-O-(CH₂)₃-Si(CH₃)₂-(CH₂)₂-Si(CH₃)₂-CH(CH₃) -,
-CH₂-O-(CH₂)₃-Si(CH₃)₂-(CH₂)₂-Si(CH₃)₂-(CH₂)₃-,
-CH₂-O-(CH₂)₃-Si(CH₃)₂-(CH₂)₂-Si(CH₃)₂-CH(CH₃)-CH₂-,
-OCH₂-,
-O(CH₂)₃-,
-OCFHCF₂-, and

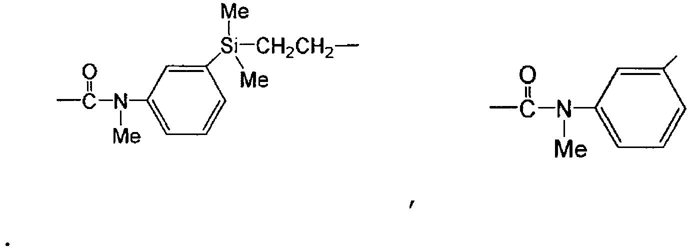

In yet another embodiment, X^{A} is each independently a group represented by formula: - (R¹⁶)ₓ₁-(CFR¹⁷)_{y1}-(CH₂)_{z1}-. In the formula, x1, y1 and z1 are each independently an integer of 0 to 10, the sum of x1, y1 and z1 is 1 or more, and the occurrence order of the respective repeating units enclosed in parentheses is not limited in the formula.

In the formulas, R¹⁶ is each independently at each occurrence an oxygen atom, phenylene, carbazolylene, -NR¹⁸-(wherein R¹⁸ represents a hydrogen atom or an organic group) or a divalent organic group. Preferably, R¹⁸ is an oxygen atom or a divalent polar group.

Examples of the "divalent polar group" include, but are not limited to, -C(O)-, -C(=NR¹⁹)- and -C(O)NR¹⁹-(wherein R¹⁹ represents a hydrogen atom or a lower alkyl group). The "lower alkyl group" is, for example, an alkyl group having 1 to 6 carbon atoms, such as methyl, ethyl or n-propyl, and these may be substituted with one or more fluorine atoms.

In the formulas, R¹⁷ is each independently at each occurrence a hydrogen atom, a fluorine atom or a lower fluoroalkyl group, and preferably a fluorine atom. The "lower fluoroalkyl group" is, for example, a fluoroalkyl group having 1 to 6 carbon atoms and preferably 1 to 3 carbon atoms, preferably a perfluoroalkyl group having 1 to 3 carbon atoms, more preferably a trifluoromethyl group or pentafluoroethyl group, and still more preferably a trifluoromethyl group.

In still another embodiment, examples of the X^{A} group include the following group: 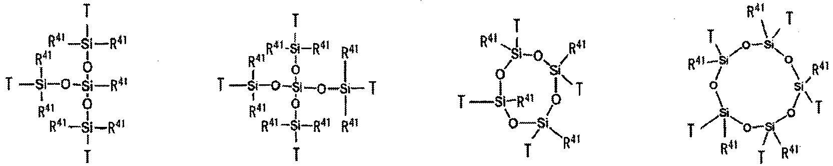 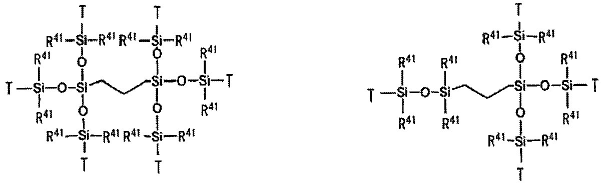 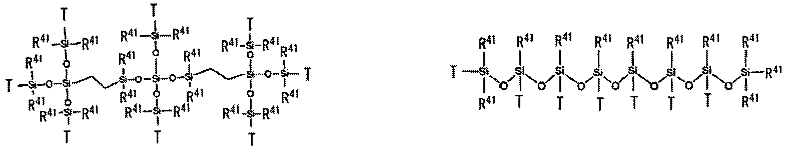 wherein
R⁴¹ each independently represents a hydrogen atom, a phenyl group, an alkyl group having 1 to 6 carbon atoms or a C₁₋₆ alkoxy group, and preferably a methyl group;
in each group X^{A}, some of the groups represented by T are the following groups bonded to R^{F1} or R^{F2} of the molecular backbone:
   - CH₂O(CH₂)₂-,
   - CH₂O(CH₂)₃-,
   - CF₂O(CH₂)₃-,
   - (CH₂)₂-,
   - (CH₂)₃-,
   - (CH₂)₄-,
   - CONH-(CH₂)₃-,
   - CON(CH₃)-(CH₂)₃-, and
   - CON(Ph)-(CH₂)₃- (wherein Ph stands for phenyl) or 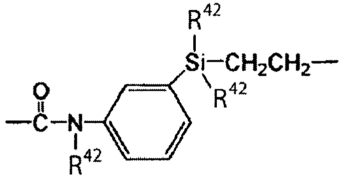
   wherein R⁴² each independently represents a hydrogen atom, a C₁₋₆ alkyl group or a C₁₋₆ alkoxy group, preferably a methyl group or a methoxy group, and more preferably a methyl group, and
   some other of the Ts binds to R^{Si} of the molecular backbone, and the remaining of the Ts, if present, is independently a methyl group, a phenyl group, a C₁₋₆ alkoxy group, or a radical scavenging group or an UV absorbing group.

The radical scavenging group is not limited as long as it can capture a radical generated by light irradiation, and, for example, residues of a benzophenone, a benzotriazole, a benzoate, a phenyl salicylate, crotonic acid, a malonate, an organo-acrylate, a hindered amine, a hindered phenol or a triazine, is mentioned.

The UV absorbing group is not limited as long as it can absorb ultraviolet rays, and, for example, a residue of a benzotriazole, a hydroxybenzophenone, an ester of a substituted and unsubstituted benzoic acid or salicylic acid compound, an acrylate or an alkoxy cinnamate, an oxamide, an oxanilide, a benzoxazinone or a benzoxazole, is mentioned.

In a preferable embodiment, examples of a preferable radical scavenging group or UV absorbing group include

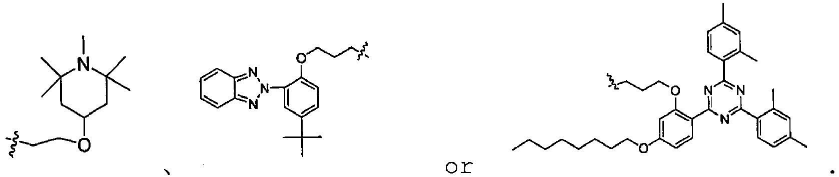

In this embodiment, X^{A} may each independently be a tri- to decavalent organic group.

In still another embodiment, examples of the X^{A} group include the following group: 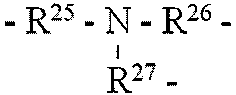 wherein R²⁵, R²⁶, and R²⁷ are each independently a di- to hexavalent organic group; and
R²⁵ binds to at least one R^{F1}, and R²⁶ and R²⁷ each bind to at least one R^{Si}.

In one embodiment, R²⁵ is a single bond, a C₁₋₂₀ alkylene group, a C₃₋₂₀ cycloalkylene group, a C₅₋₂₀ arylene group, -R⁵⁷-X⁵⁸-R⁵⁹-, -X⁵⁸-R⁵⁹-, or -R⁵⁷-X⁵⁸-. R⁵⁷ and R⁵⁹ are each independently a single bond, a C₁₋₂₀ alkylene group, a C₃₋₂₀ cycloalkylene group, or a C₅₋₂₀ arylene group. X⁵⁸ is - O-, -S-, -CO-, -O-CO-, or -COO-.

In one embodiment, R²⁶ and R²⁷ are each independently a hydrocarbon or a group having at least one atom selected from N, O and S at the end or in the backbone of a hydrocarbon, preferably including a C₁₋₆ alkyl group, -R³⁶-R³⁷-R³⁶-, -R³⁶-CHR³⁸₂-, and the like. Here, R³⁶ is each independently a single bond or an alkyl group having 1 to 6 carbon atoms, preferably an alkyl group having 1 to 6 carbon atoms. R³⁷ is N, O or S, preferably N or O. R³⁸ is -R⁴⁵-R⁴⁶-R⁴⁵-, -R⁴⁶-R⁴⁵- or -R⁴⁵-R⁴⁶-. R⁴⁵ is each independently an alkyl group having 1 to 6 carbon atoms. R⁴⁶ is N, O or S, preferably O.

In this embodiment, X^{A} may each independently be a tri- to decavalent organic group.

The fluoropolyether group-containing compound represented by the formula (1) or the formula (2) is not limited, but may have an average molecular weight of 5 × 10² to 1 × 10⁵. In particular, the compound preferably has a number average molecular weight of 2,000 to 32,000, and more preferably 2,500 to 12,000, from the viewpoint of friction durability. The "average molecular weight" refers to a number average molecular weight, and the "average molecular weight" is a value obtained by ¹⁹F-NMR measurement.

In one embodiment, the fluorine-containing silane compound in the surface-treating agent of the present disclosure is the compound represented by the formula (1).

In another embodiment, the fluorine-containing silane compound in the surface-treating agent of the present disclosure is the compound represented by the formula (2).

In another embodiment, the fluorine-containing silane compound in the surface-treating agent of the present disclosure is the compound represented by formula (1) and the compound represented by formula (2).

In the surface-treating agent of the present disclosure, the compound represented by the formula (2) is preferably 0.1 mol% or more and 35 mol% or less based on the total of the compound represented by the formula (1) and the compound represented by the formula (2). The lower limit of the content of the compound represented by the formula (2) based on the total of the compound represented by the formula (1) and the compound represented by the formula (2) may be preferably 0.1 mol%, more preferably 0.2 mol%, still more preferably 0.5 mol%, and further preferably 1 mol%, particularly preferably 2 mol%, and especially 5 mol%. The upper limit of the content of the compound represented by the formula (2) based on the total of the compound represented by the formula (1) and the compound represented by the formula (2) may be preferably 35 mol%, more preferably 30 mol%, still more preferably 20 mol%, and further preferably 15 mol% or 10 mol%. The compound represented by the formula (2) based on the total of the compound represented by the formula (1) and the compound represented by the formula (2) is preferably 0.1 mol% or more and 30 mol% or less, more preferably 0.1 mol% or more and 20 mol% or less, still more preferably 0.2 mol% or more and 10 mol% or less, further preferably 0.5 mol% or more and 10 mol% or less, and particularly preferably 1 mol% or more and 10 mol% or less, for example, 2 mol% or more and 10 mol% or less, or 5 mol% or more and 10 mol% or less. With the compound represented by the formula (2) being within such a range, friction durability can be more increased.

The compound represented by the formula (1) or (2) can be obtained, for example, by the methods described in Patent Literature 1, Patent Literature 2 and the like.

The metal compound may be a metal single substance, a compound of a metal atom and another atom, for example, a compound in which a reactive group is bonded, a salt, another organometallic compound, or the like.

Herein, the metal atom contained in the metal compound also encompasses semimetals such as B, Si, Ge, Sb, As, and Te.

The metal atom contained in the metal compound is one or more metal atoms selected from transition metal atoms of Groups 3 to 11 and typical metal atoms of Groups 12 to 15 of the periodic table. The metal atom is preferably one or more metal atoms selected from transition metal atoms of Groups 3 to 11 and typical metal atoms of Groups 12 to 15 (excluding Si) of the periodic table, more preferably transition metal atoms of Groups 3 to 11, still more preferably transition metal atoms of Groups 3 to 7, and further preferably transition metal atoms of Groups 4 to 6. With the surface-treating agent containing such a metal atom, the metal atom is allowed be present in the surface-treating layer formed from the surface-treating agent, whereby the friction durability and chemical resistance of the surface-treating layer can be improved.

In one embodiment, the metal atom is one or more atoms selected from Ta, Nb, Zr, Mo, W, Cr, Hf, Al, Ti and V. By using such a metal species, the friction durability and chemical resistance of the surface-treating layer can be further improved.

In a preferable embodiment, the metal atom is Ta, Nb, W, Mo, Cr or V. By using such a metal species, the friction durability and chemical resistance of the surface-treating layer can be further improved.

In a still more preferable embodiment, the metal atom is Ta. By employing tantalum as the metal atom, the friction durability and chemical resistance of the surface-treating layer can be further improved.

In a preferable embodiment, the metal compound is a metal compound represented by M-R (wherein M is a metal atom and R is a hydrolyzable group). By using the metal compound as a compound in which a metal and a hydrolyzable group are bonded, metal atoms can be more efficiently contained in the surface-treating layer, and the friction durability and chemical resistance of the surface-treating layer can be further improved.

The hydrolyzable group refers to a group which can undergo a hydrolysis reaction, similarly to the hydrolyzable group relating to the fluorine-containing silane, that is, a group capable of being removed from a metal atom by a hydrolysis reaction. Examples of the hydrolyzable group include -OR^{m}, -OCOR^{m}, -O-N=CR^{m}₂, -NR^{m}₂, - NHR^{m}, and halogen (in these formulas, R^{m} represents a substituted or unsubstituted C₁₋₄ alkyl group).

In a preferable embodiment, the hydrolysable group is -OR^{m}, preferably methoxy or ethoxy. By using an alkoxy group as the hydrolyzable group, metal atoms can be more efficiently contained in the surface-treating layer, and the friction durability and chemical resistance of the surface-treating layer can be further improved.

In one embodiment, the hydrolyzable group may be the same as the hydrolyzable group contained in the fluorine-containing silane compound. By using the same hydrolyzable group for the fluorine-containing silane compound and the metal compound, even when such hydrolyzable groups are exchanged with each other, the influence thereof can be reduced.

In another embodiment, the hydrolyzable group may be different from the hydrolyzable group contained in the fluorine-containing silane compound. With the hydrolyzable groups in the fluorine-containing silane compound and the metal compound being different from each other, the reactivity of hydrolysis can be controlled.

In one embodiment, the hydrolyzable group and the hydrolyzable group contained in the fluorine-containing silane compound may be interchanged in the surface-treating agent.

In a preferable embodiment, the metal compound may be Ta(OR^{m})₅, preferably Ta (OCH₂CH₃)₅.

The metal compound is contained in the surface-treating agent at a molar ratio of preferably 0.1 to 10 times, more preferably 0.2 to 5 times, and still more preferably 0.3 to 3 times the fluorine-containing silane compound. With the content of the metal compound being within the above range, the friction durability and chemical resistance of the surface-treating layer can be further improved.

The surface-treating agent of the present disclosure may include a solvent, a (unreactive) fluoropolyether compound which can be understood as a fluorine-containing oil, preferably a perfluoro(poly)ether compound (hereinafter, collectively referred to as "fluorine-containing oil"), a (unreactive) silicone compound which can be understood as a silicone oil (hereinafter, referred to as "silicone oil"), an alcohol, a catalyst, a surfactant, a polymerization inhibitor, a sensitizer, and the like.

Examples of the solvent include aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, isopropanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide and N,N-dimethylacetamide; ether alcohols such as methyl cellosolve, cellosolve, isopropyl cellosolve, butyl cellosolve, and diethylene glycol monomethyl ether; diethylene glycol monoethyl ether acetate; and fluorine-containing solvents such as 1,1,2-trichloro-1,2,2-trifluoroethane, 1,2-dichloro-1,1,2,2-tetrafluoroethane, dimethyl sulfoxide, 1,1-dichloro-1,2,2,3,3-pentafluoropropane (HCFC 225), Zeorora H, HFE 7100, HFE 7200, HFE 7300, CF₃CH₂OH, CF₃CF₂CH₂OH, and (CF₃)₂CHOH. Alternatively, the solvent may be a mixed solvent of two or more of such solvents.

The fluorine-containing oil is not limited, and examples thereof include a compound (perfluoro(poly)ether compound) represented by the following general formula (3):

Rf⁵-(OC₄F₈)_{a'}-(OC₃F₆)_{b'}-(OC₂F₄)_{c'}-(OCF₂)_{d'}-Rf⁶ ... (3)

wherein Rf⁵ represents an alkyl group having 1 to 16 carbon atoms optionally substituted with one or more fluorine atoms (preferably, C₁₋₁₆ perfluoroalkyl group), Rf⁶ represents an alkyl group having 1 to 16 carbon atoms optionally substituted with one or more fluorine atoms (preferably, C₁₋₁₆ perfluoroalkyl group), a fluorine atom, or a hydrogen atom, and Rf⁵ and Rf⁶ are each independently, more preferably, a C₁₋₃ perfluoroalkyl group; and
a', b', c' and d' represent the respective four numbers of repeating units in perfluoro(poly)ether constituting a main backbone of the polymer and are mutually independently an integer of 0 or more and 300 or less, the sum of a', b', c' and d' is at least 1, preferably 1 to 300, more preferably 20 to 300, the occurrence order of the respective repeating units enclosed in parentheses provided with a subscript a', b', c' or d' is not limited in the formula, and among such repeating units, for example, -(OC₄F₈)- may be any of - (OCF₂CF₂CF₂CF₂)-, - (OCF(CF₃)CF₂CF₂) -, -(OCF₂CF(CF₃)CF₂)-, - (OCF₂CF₂CF(CF₃))-, - (OC(CF₃)₂CF₂)-, - (OCF₂C(CF₃)₂)-, - (OCF(CF₃)CF(CF₃))-, - (OCF(C₂F₅)CF₂)- and - (OCF₂CF(C₂F₅)) - and is preferably - (OCF₂CF₂CF₂CF₂)-, - (OC₃F₆)- may be any of - (OCF₂CF₂CF₂)-, -(OCF(CF₃)CF₂)- and - (OCF₂CF(CF₃)) - and is preferably -(OCF₂CF₂CF₂)-, and -(OC₂F₄)- may be any of - (OCF₂CF₂)- and -(OCF(CF₃))- and is preferably -(OCF₂CF₂)-.

Examples of the perfluoro(poly)ether compound represented by general formula (3) include a compound represented by any of the following general formulas (3a) and (3b) (which may be adopted singly or as a mixture of two or more kinds thereof):

Rf⁵-(OCF₂CF₂CF₂)_{b''}-Rf⁶ ... (3a)

Rf⁵-(OCF₂CF₂CF₂CF₂)_{a''}-(OCF₂CF₂CF₂)_{b''}-(OCF₂CF₂)_{c''}-(OCF₂)_{d''}-Rf⁶ ... (3b)

In such formulas, Rf⁵ and Rf⁶ are as described above; in formula (3a), b'' is an integer of 1 or more and 100 or less; and, in formula (3b), a'' and b'' are each independently an integer of 0 or more and 30 or less, c'' and d'' are each independently an integer of 1 or more and 300 or less. The occurrence order of the respective repeating units enclosed in parentheses provided with a subscript a'', b'', c'', or d'' is not limited in the formulas.

From another viewpoint, the fluorine-containing oil may be a compound represented by general formula Rf³-F wherein Rf³ is a C₅₋₁₆ perfluoroalkyl group. The fluorine-containing oil may be a chlorotrifluoroethylene oligomer.

The fluorine-containing oil may have an average molecular weight of 500 to 10,000. The molecular weight of the fluorine-containing oil may be measured using GPC.

The fluorine-containing oil may be contained in an amount of, for example, 0 to 50 mass%, preferably 0 to 30 mass%, and more preferably 0 to 5 mass% based on the surface-treating agent of the present disclosure. In one embodiment, the surface-treating agent of the present disclosure is substantially free of the fluorine-containing oil. Being substantially free of the fluorine-containing oil means that the fluorine-containing oil is not contained at all, or an extremely small amount of the fluorine-containing oil may be contained.

In one embodiment, the average molecular weight of the fluorine-containing oil may be greater than the average molecular weight of the fluorine-containing silane compound. With such average molecular weights, better friction durability and surface lubricity can be obtained, in the case of forming the surface-treating layer by the vacuum deposition method.

In one embodiment, the average molecular weight of the fluorine-containing oil may be smaller than the average molecular weight of the fluorine-containing silane compound. With such average molecular weights, a cured product having high friction durability and high surface lubricity can be formed while suppressing the deterioration in transparency of the surface-treating layer obtained from the compound.

The fluorine-containing oil contributes to enhancing surface lubricity of the layer formed by the surface-treating agent of the present disclosure.

For example, the silicone oil may be linear or cyclic silicone oil having 2,000 or less siloxane bonds. The linear silicone oil may be so-called straight silicone oil or modified silicone oil. Examples of the straight silicone oil include dimethyl silicone oil, methyl phenyl silicone oil, and methyl hydrogen silicone oil. Examples of the modified silicone oil include those obtained by modifying straight silicone oil with alkyl, aralkyl, polyether, higher fatty acid ester, fluoroalkyl, amino, epoxy, carboxyl, alcohol, or the like. Examples of the cyclic silicone oil include cyclic dimethylsiloxane oil.

In the surface-treating agent of the present disclosure, such a silicone oil may be contained in an amount of, for example, 0 to 300 parts by mass, and preferably 50 to 200 parts by mass, based on total 100 parts by mass of the above fluoropolyether group-containing silane compound of the present disclosure (in the case of two or more kinds, the total thereof, and the same applies below).

Silicone oil contributes to increasing the surface lubricity of the surface-treating layer.

Examples of the alcohols include alcohols having 1 to 6 carbon atoms optionally substituted with one or more fluorine atoms, such as methanol, ethanol, iso-propanol, tert-butanol, CF₃CH₂OH, CF₃CF₂CH₂OH, and (CF₃)₂CHOH. By adding these alcohols to the surface-treating agent, the stability of the surface-treating agent is improved and the miscibility between the perfluoropolyether group-containing silane compound and the solvent is improved.

The alcohol is contained in the surface-treating agent at a molar ratio of preferably 0.1 to 5 times, more preferably 0.5 to 3 times, and still more preferably 0.8 to 1.2 times the metal compound. With the content of alcohols being within the above range, the stability of the surface-treating layer can be further improved.

Examples of the catalyst include acids (such as acetic acid and trifluoroacetic acid), bases (such as ammonia, triethylamine, and diethylamine), and transition metals (such as Ti, Ni, and Sn).

The catalyst promotes hydrolysis and dehydration condensation of the fluorine-containing silane compound of the present disclosure, and promotes formation of the layer to be formed from the surface-treating agent of the present disclosure.

Examples of other components include, in addition to those described above, tetraethoxysilane, methyltrimethoxysilane, 3-aminopropyltrimethoxysilane, 3-glycidoxypropyltrimethoxysilane, and methyltriacetoxysilane.

The surface-treating agent of the present disclosure can be formed into pellets by impregnating a porous material such as a porous ceramic material or a metal fiber such as a fiber obtained by, for example, solidifying steel wool in a cotton-like form with the composition. Such pellets can be used in, for example, vacuum deposition.

The surface-treating agent of the present disclosure may contain, in addition to the above-described components, a trace amount of impurities such as Pt, Rh, Ru, 1,3-divinyltetramethyldisiloxane, triphenylphosphine, NaCl, KCl, and a condensation product of silane.

Hereinafter, an article of the present disclosure will be described.

The article of the present disclosure comprises a substrate and a layer (surface-treating layer) formed on a surface of the substrate from the surface-treating agent of the present disclosure.

The substrate usable in the present disclosure may be composed of any suitable material such as glass, resin (which may be natural or synthetic resin such as a commonly used plastic material), metal, ceramics, semiconductors (such as silicon and germanium), fiber (such as woven fabric and nonwoven fabric), fur, leather, wood, pottery, stone, building materials, and sanitary articles.

For example, when the article to be produced is an optical member, the material constituting the surface of the substrate may be a material for an optical member, such as glass or a transparent plastic. When the article to be produced is an optical member, some layer (or film) such as a hard coat layer or an antireflection layer may be formed on the surface (the outermost layer) of the substrate. The antireflection layer may be any of a single-layer antireflection layer and a multi-layer antireflection layer. Examples of inorganic substances usable in the antireflection layer include SiO₂, SiO, ZrO₂, TiO₂, TiO, Ti₂O₃, Ti₂O₅, Al₂O₃, Ta₂O₅, Ta₃O₅, Nb₂O₅, HfO₂, Si₃N₄, CeO₂, MgO, Y₂O₃, SnO₂, MgF₂, and WO₃. One of these inorganic substances may be used singly, or two or more may be used in combination (e.g., as a mixture). In the case of a multi-layer antireflection layer, SiO₂ and/or SiO is preferably used in the outermost layer thereof. When the article to be produced is an optical glass component for a touch panel, a part of the surface of the substrate (glass) may have a transparent electrode such as a thin film in which indium tin oxide (ITO), indium zinc oxide, or the like is used. The substrate, according to its specific configuration or the like, may have an insulating layer, an adhesive layer, a protecting layer, a decorated frame layer (I-CON), an atomizing film layer, a hard coating layer, a polarizing film, a phase difference film, a liquid crystal display module, or the like.

The shape of the substrate is not limited, and may be, for example, in the form of a plate, a film, or the like. The surface region of the substrate on which a surface-treating layer is to be formed is at least a part of the substrate surface, and may be suitably determined according to the application, specific specifications, and the like of an article to be produced.

In one embodiment, the substrate, or at least the surface portion thereof, may be composed of a material originally having a hydroxyl group. Examples of the material include glass as well as metal (in particular, base metal) wherein a natural oxidized film or a thermal oxidized film is formed on the surface, ceramics, semiconductors, and the like. Alternatively, when the substrate has an insufficient amount of a hydroxyl group or when the substrate originally does not have a hydroxyl group as in resin and the like, a pre-treatment may be performed on the substrate to thereby introduce or increase a hydroxyl group on the surface of the substrate. Examples of such a pre-treatment include a plasma treatment (e.g., corona discharge) and ion beam irradiation. The plasma treatment can be suitably utilized to not only introduce or increase a hydroxyl group on the substrate surface, but also clean the substrate surface (remove foreign matter and the like). Another example of the pre-treatment includes a method wherein a monolayer of a surface adsorbent having a carbon-carbon unsaturated bonding group is formed on the substrate surface by a LB method (a Langmuir-Blodgett method), a chemical adsorption method, or the like beforehand, and thereafter cleaving the unsaturated bond under an atmosphere containing oxygen, nitrogen, or the like.

In another embodiment, the substrate may be that of which at least the surface consists of a material comprising other reactive group such as a silicone compound having one or more Si-H group or alkoxysilane.

In a preferable embodiment, the substrate is glass. The glass is preferably sapphire glass, soda-lime glass, alkali aluminosilicate glass, borosilicate glass, alkali-free glass, crystal glass, or quartz glass, particularly preferably chemically strengthened soda-lime glass, chemically strengthened alkali aluminosilicate glass, and chemically bonded borosilicate glass.

The article of the present disclosure can be produced by forming a layer of the surface-treating agent of the present disclosure on a surface of the substrate, and post-treating this layer as necessary to thereby form a layer from the surface-treating agent of the present disclosure.

The layer of the surface-treating agent of the present disclosure can be formed by applying the above surface-treating agent on the surface of the substrate such that the composition coats the surface. The coating method is not limited. For example, a wet coating method and a dry coating method can be used.

Examples of the wet coating method include dip coating, spin coating, flow coating, spray coating, roll coating, gravure coating, and similar methods.

Examples of the dry coating method include deposition (usually, vacuum deposition), sputtering, CVD, and similar methods. Specific examples of the deposition method (usually, a vacuum deposition method) include resistive heating, high-frequency heating using electron beam, microwave or the like, ion beam, and similar methods. Specific examples of the CVD method include plasma-CVD, optical CVD, thermal CVD, and similar methods.

Furthermore, coating by an atmospheric pressure plasma method can be performed.

When using the wet coating method, the surface-treating agent of the present disclosure can be applied to the substrate surface after being diluted with a solvent. From the viewpoint of the stability of the composition of the present disclosure and the volatility of solvents, the following solvents are preferably used: perfluoroaliphatic hydrocarbons having 5 to 12 carbon atoms (such as perfluorohexane, perfluoromethylcyclohexane, and perfluoro-1,3-dimethylcyclohexane); polyfluoroaromatic hydrocarbons (such as bis(trifluoromethyl)benzene); polyfluoroaliphatic hydrocarbons (such as C₆F₁₃CH₂CH₃ (such as Asahiklin (registered trademark) AC-6000 manufactured by Asahi Glass Co., Ltd., and 1,1,2,2,3,3,4-heptafluorocyclopentane (such as Zeorora (registered trademark) H manufactured by Zeon Corporation)); alkyl perfluoroalkyl ethers (the perfluoroalkyl group and the alkyl group may be linear or branched) such as hydrofluoroether (HFE) (such as perfluoropropylmethyl ether (C₃F₇OCH₃) (such as Novec (trademark) 7000 manufactured by Sumitomo 3M Limited), perfluorobutyl methyl ether (C₄F₉OCH₃) (such as Novec (trademark) 7100 manufactured by Sumitomo 3M Limited), perfluorobutyl ethyl ether (C₄F₉OC₂H₅) (such as Novec (trademark) 7200 manufactured by Sumitomo 3M Limited), and perfluorohexyl methyl ether (C₂F₅CF(OCH₃)C₃F₇) (such as Novec (trademark) 7300 manufactured by Sumitomo 3M Limited), or CF₃CH₂OCF₂CHF₂ (such as Asahiklin (registered trademark) AE-3000 manufactured by Asahi Glass Co., Ltd.)). One of these solvents can be used singly, or two or more can be used as a mixture. In particular, hydrofluoroether is preferable, and perfluorobutyl methyl ether (C₄F₉OCH₃) and/or perfluorobutyl ethyl ether (C₄F₉OC₂H₅) is particularly preferable.

When using the dry coating method, the surface-treating agent of the present disclosure may be directly subjected to the dry coating method, or may be diluted with the above solvent before being subjected to the dry coating method.

A layer of the surface-treating agent is preferably formed such that the surface-treating agent of the present disclosure coexists in the layer with a catalyst for hydrolysis and dehydrative condensation. Conveniently, in the case of a wet coating method, the surface-treating agent of the present disclosure is diluted with a solvent, and then, immediately before application to the substrate surface, a catalyst may be added to the diluted solution of the surface-treating agent of the present disclosure. In the case of a dry coating method, the surface-treating agent of the present disclosure to which a catalyst has been added is directly used to a deposition (usually vacuum deposition) treatment, or a pellet-like material may be used to a deposition (usually vacuum deposition) treatment, wherein the pellet is obtained by impregnating a porous body of metal such as iron or copper with the surface-treating agent of the present disclosure to which the catalyst has been added.

The catalyst may be any suitable acid or base. The acid catalyst may be, for example, acetic acid, formic acid, or trifluoroacetic acid. The base catalyst may be, for example, ammonia or organic amine.

As described above, the article of the present disclosure is produced by forming a surface-treating layer on a substrate using a surface-treating agent comprising a fluorine-containing silane compound and a metal compound. Thus, the surface-treating layer in the article of the present disclosure contains metal atoms from a metal compound.

Accordingly, the present disclosure provides an article comprising a substrate and a surface-treating layer formed on the substrate, wherein the surface-treating layer is formed from a fluorine-containing silane compound and comprises one or more metal atoms selected from transition metal atoms of Groups 3 to 11 and typical metal atoms of Groups 12 to 15 of the periodic table.

In the article, the fluorine-containing silane compound is a fluorine-containing silane compound contained in the surface-treating agent of the present disclosure. Accordingly, the fluorine-containing silane compound forming the surface-treating layer contained in the article has the same embodiment as the fluorine-containing silane contained in the surface-treating agent described above. For example, in one embodiment, the fluorine-containing silane compound is at least one fluoropolyether group-containing compound represented by the following formula (1) or (2):

R^{F1} _{α} - X^{A} - R^{Si} _{β} (1)

R^{Si} _{γ} - X^{A} - R^{F2}- X^{A} - R^{Si} _{γ} (2)

wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

In the article, the metal atom is a metal atom constituting a metal compound contained in the surface-treating agent of the present disclosure. Therefore, the metal atom contained in the surface-treating layer contained in the article has the same embodiment as the metal related to the metal compound contained in the surface-treating agent described above. For example, the metal atom is preferably one or more metal atoms selected from transition metal atoms of Groups 3 to 11 and typical metal atoms of Groups 12 to 15 (excluding Si) of the periodic table, more preferably transition metal atoms of Groups 3 to 11, still more preferably transition metal atoms of Groups 3 to 7, and further preferably transition metal atoms of Groups 4 to 6.

In one embodiment, the metal atom is one or more atoms selected from Ta, Nb, Zr, Mo, W, Cr, Hf, Al, Ti and V.

In a preferable embodiment, the metal atom is Ta, Nb, W, Mo, Cr or V.

In a still more preferable embodiment, the metal atom is Ta.

The atomic compositional features and the ratio of constituent atoms of the surface-treating layer can be determined by surface analysis and depth direction analysis. X-ray photoelectron spectroscopy, time-of-flight secondary ion mass spectrometry, or the like can be used as the analysis method.

### (Surface analysis)

As an apparatus for performing X-ray photoelectron spectroscopy for measuring atomic compositional features and the ratio of constituent atoms of the surface-treating layer, XPS, PHI 5000 VersaProbe II manufactured by ULVAC-PHI, Inc. can be used. The measurement conditions of the XPS can be as follows: the X-ray source is 25 W monochromatic AlKα radiation; the photoelectron detection surface is 1,400 µm × 300 µm; the photoelectron detection angle is 20°, 45°, and 90°; the pass energy is 23.5 eV; and Ar ions are used as sputtering ions. The compositional features of the laminate can be determined by observing the peak areas of C1s, O1s, F1s, and Si2p orbitals, and the appropriate orbital of metal atoms under the above-described apparatus and measurement conditions and calculating the atomic ratio of carbon, oxygen, fluorine, silicon, and metal atoms. Examples of suitable orbits of the metal atoms include 1s orbits for atomic number 5 (B), 2p orbits for atomic numbers 13 to 14 and 21 to 31 (Al to Si and Sc to Ga), 3d orbits for atomic numbers 32 to 33 and 39 to 52 (Ge to As and Y to Te), and 4f orbits for atomic numbers 72 to 83 (Hf to Bi).

### (Depth direction analysis)

It is also possible to analyze the surface-treating layer in the depth direction. The measurement conditions of the XPS can be as follows: the X-ray source is 25 W monochromatic AlKα radiation; the photoelectron detection surface is 1,400 µm × 300 µm; the photoelectron detection angle is 45°; the pass energy is 23.5 eV; and Ar ions are used as sputtering ions. The surface layer of the laminate is etched by sputtering with Ar ions to a thickness of 1 to 100 nm, and the peak areas of C1s, O1s, F1s, and Si2p orbitals, and appropriate orbitals of metal atoms are observed at the respective etched depths, and the atomic ratios of carbon, oxygen, fluorine, silicon, and other metal atoms are calculated, whereby the compositional features of the interior of the laminate can be determined. Examples of suitable orbits of the metal atoms include 1s orbits for atomic number 5 (B), 2p orbits for atomic numbers 13 to 14 and 21 to 31 (Al to Si and Sc to Ga), 3d orbits for atomic numbers 32 to 33 and 39 to 52 (Ge to As and Y to Te), and 4f orbits for atomic numbers 72 to 83 (Hf to Bi).

When the surface-treating layer contained in the article of the present disclosure is subjected to surface analysis (photoelectron detection angle of 45 degrees) as described above, the metal atom is present in the surface-treating layer in an amount of preferably 0.03 to 3.0 at%, more preferably 0.1 to 1.0 at%, still more preferably 0.1 to 0.5 at%, and more preferably 0.1 to 0.3 at% based on the total amount of carbon, oxygen, fluorine, silicon, and metal atom (for example, tantalum). By containing the metal atoms in the surface-treating layer at such a ratio, the friction durability and chemical resistance of the surface-treating layer can be more reliably improved.

When the surface-treating layer contained in the article of the present disclosure is subjected to surface analysis (photoelectron detection angle of 45 degrees) as described above, the molar ratio (C/M ratio) of carbon atoms to metal atoms in the surface-treating layer may preferably be 10 to 1,000, and more preferably 50 to 500. With the ratio of carbon atoms to metal atoms within such a range, the friction durability and chemical resistance of the surface-treating layer can be more reliably improved.

The surface-treating layer contained in the article of the present disclosure may contain a trace amount of impurities such as Pt, Rh, Ru, 1,3-divinyltetramethyldisiloxane, triphenylphosphine, NaCl, KCl, and a condensation product of silane.

The surface-treating layer contained in the article of the present disclosure has both high surface lubricity and high friction durability. The surface-treating layer may have not only high friction durability and chemical resistance but also have, depending on the compositional features of the surface-treating agent used, water-repellency, oil-repellency, antifouling properties (e.g., preventing grime such as fingerprints from adhering), waterproof properties (preventing water from entering electronic components and the like), surface lubricity (or lubricity, for example, such as removability by wiping of grime such as fingerprints, and excellent tactile sensations to the fingers), and the like, and may be suitably used as a functional thin film.

Accordingly, the present disclosure further relates to an optical material having the surface-treating layer as an outermost layer.

The optical material preferably includes a wide variety of optical materials in addition to optical materials relating to displays and the like as exemplified below: for example, displays such as cathode ray tubes (CRTs; e.g., PC monitors), liquid crystal displays, plasma displays, organic EL displays, inorganic thin-film EL dot matrix displays, rear projection displays, vacuum fluorescent displays (VFDs), field emission displays (FEDs); protective plates for such displays; and those obtained by performing an antireflection film treatment on their surfaces.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for devices such as mobile phones and personal digital assistants; disc surfaces of optical discs such as Blu-ray (registered trademark) discs, DVD discs, CD-Rs, and MOs; optical fibers; and display surfaces of watches and clocks.

The article of the present disclosure may be medical equipment or a medical material.

The thickness of the layer is not limited. The thickness of the layer in the case of an optical member is in the range of 1 to 50 nm, 1 to 30 nm, and preferably 1 to 15 nm, from the viewpoint of optical performance, surface lubricity, friction durability, and antifouling properties.

The present disclosure further provides
a method for producing an article comprising a substrate and a surface-treating layer formed on the substrate, wherein the surface-treating layer is formed from a fluorine-containing silane compound and comprises one or more metal atoms selected from transition metal atoms of Groups 3 to 11 and typical metal atoms of Groups 12 to 15 of the periodic table,
the method comprising depositing the fluorine-containing silane compound and a metal compound containing the metal atom on the substrate using a surface-treating agent containing the fluorine-containing silane compound and the metal compound containing the metal atom to form the surface-treating layer.

The article of the present disclosure has been described in detail above. The article of the present disclosure, the method for producing the article, and the like are not limited to those exemplified above.

### Examples

Hereinafter, an article of the present disclosure will be described in Examples, but the present disclosure is not limited to the following Examples.

### (Preparation of surface-treating agent)

### Surface-treating agents 1 to 4

Surface-treating agents 1 to 3 were prepared by adding 0.21 g, 0.12 g, and 0.025 g of Ta(OCH₂CH₃)₅ (manufactured by Kojundo Chemical Lab. Co., Ltd.) to 4 g of a solution of the following perfluoropolyether group-containing silane compounds diluted with HFE 7200 to 20% by mass, respectively. The above compound was diluted with HFE 7200 to 20% by mass to prepare a surface-treating agent 4 of Comparative Example.
- Perfluoropolyether group-containing silane compound CF₃CF₂CF₂O(CF₂CF₂CF₂O)₂₃CF₂CF₂CONHCH₂C[CH₂CH₂CH₂Si(OCH₃)₃]₃

### Surface-treating agents 5 and 6

Surface-treating agents 5 and 6 were prepared by adding 0.21 g of iso-propanol (manufactured by Tokyo Chemical Industry Co., Ltd.) and 0.21 g of CF₃CF₂CH₂OH (manufactured by Daikin Industries, Ltd.), respectively, to the surface-treating agent 1 prepared above.

### (Formation of surface-treating layer)

The surface-treating agents 1 to 6 prepared above were vacuum deposited on chemically strengthened and surface-polished Gorilla Glass 3 (Corning) with a thickness of 0.5 mm, 71.5 mm × 149.0 mm. Specifically, a resistance heating boat in the vacuum deposition system was filled with the surface-treating agents 1 to 6 (0.05 g), and the vacuum deposition system was evacuated to a pressure of 3.0 × 10⁻³ Pa or lower. Next, a silicon dioxide film having a thickness of 5 nm was formed on Gorilla Glass 3, and the temperature of the resistance heating boat was raised to form a film on the chemically strengthened glass. Next, the chemically strengthened glass with a deposited film was left to stand in an atmosphere at a temperature of 150°C for 30 minutes, and then allowed to cool to room temperature to form a surface-treating layer on the substrate, thereby obtaining glass substrates with a surface-treating layer of Examples 1 to 5 (surface-treating agents 1 to 3, 5, and 6) and Comparative Example 1 (surface-treating agent 4).

### <Evaluation>

The glass substrate with the surface-treating layer obtained above was each subjected to measurement of the water contact angle, alkali test, and evaluation of friction durability as follows.

### (Alkali immersion test)

PTFE (polytetrafluoroethylene) O-rings 1 cm in diameter were placed on the surfaces of the glass substrates of Example 1 and Comparative Example 1 on which the surface-treating layer had been formed, and 8N NaOH solutions were dropped into the O-rings, the surfaces of the surface-treating layers were brought into contact with the aqueous alkali solutions, and alkali immersion tests were performed. After 20 to 120 minutes of the alkali immersion test, the NaOH was wiped off and washed with pure water and ethanol, and then the contact angle with water was measured. The static contact angles of water were measured by dropping 2 µL of a water droplet of pure water on the surfaces of the glass substrates after the alkali immersion test and using a contact-angle meter (automatic contact-angle meter DropMaster701 manufactured by Kyowa Interface Science Co., Ltd.). The static contact angle of water after the alkali immersion test was measured at five points. The relationship between the immersion time and the average value of the contact angles at five points is shown in Table 1 below.

**[Table 1]**

| | Static contact angle of water for alkali immersion test (°) | | | | | |
|---|---|---|---|---|---|---|
| Time (min) | 0 | 20 | 40 | 60 | 90 | 120 |
| Example 1 | 114 | 115 | 111 | 105 | 96 | 71 |
| Comparative Example 1 | 116 | 115 | 116 | 111 | 57 | 29 |

### (Friction durability test)

The sample article on which the surface-treating layer was formed was horizontally disposed, the following friction element was brought into contact with the surface of the surface-treating layer (the contact surface was a circle having a 1 cm diameter), a 5N load was applied thereon, and then the friction block was reciprocated at a speed of 40 mm/sec in a state in which the load was applied. The friction block was reciprocated up to 10,000 times, and the static contact angle (°) of water was measured every 1,000 times of reciprocation (Friction frequency). The test was stopped when the measured value of the static contact angle of water was less than 80°. The static contact angle of water was measured in the same manner as in the alkali test. The results are shown in Table 2 below.

### - Friction block

The surfaces (1 cm diameter) of the silicone rubber processed products shown below were covered with cotton soaked in artificial sweat having the compositional features shown below, and the products were used as friction blocks.

Compositional feature of artificial sweat:
Anhydrous disodium hydrogen phosphate: 2 g
Sodium chloride: 20 g
85% Lactic acid: 2 g
Histidine hydrochloride: 5 g
Distilled water: 1 kg

### Silicone rubber processed product:

Silicone rubber stopper SR-51 made of Tiger's polymer processed into a cylindrical shape having a diameter of 1 cm and a thickness of 1 cm.

**[Table 2]**

| Friction frequency (times) | Static contact angle (°) | | | | | |
|---|---|---|---|---|---|---|
| | Example 1 | Example 2 | Example 3 | Example 4 | Example 5 | Comparative Example 1 |
| 0 | 114 | 113 | 113 | 114 | 113 | 114 |
| 1000 | 110 | 111 | 110 | 111 | 110 | 108 |
| 2000 | 107 | 107 | 105 | 108 | 106 | 104 |
| 3000 | 104 | 104 | 99 | 105 | 102 | 99 |
| 4000 | 101 | 101 | 93 | 102 | 97 | 87 |
| 5000 | 96 | 99 | 86 | 99 | 93 | 79 |
| 6000 | 92 | 94 | 79 | 96 | 87 | - |
| 7000 | 89 | 91 | - | 92 | 82 | - |
| 8000 | 84 | 85 | - | 86 | 76 | - |
| 9000 | 80 | 72 | - | 83 | - | - |
| 10000 | - | - | - | 80 | - | - |

### (Surface analysis)

The surface compositional feature of the surface-treating layer of the above treated glass substrates was analyzed using an X-ray photoelectron spectrometer (XPS, PHI 5000 VersaProbe II manufactured by ULVAC-PHI, Inc.). The measurement conditions for XPS analysis were as follows.
X-ray source : monochromatic AlKα radiation (25 W)
Photoelectron detection area: 1,400 µm × 300 µm
Photoelectron detection angle: 45 degrees
Path energy : 23.5 eV

For the glass substrates with the surface-treating layer of Example 1 and Comparative Example 1, the peak areas of C1s, O1s, F1s, Si2p, and Ta4f orbitals were observed by XPS, and the atomic ratios and area ratios of carbon, oxygen, fluorine, silicon, and tantalum were calculated to obtain the compositional features of the treated surface including the surface-treating antifouling layer. The results are shown in Table 3 below for Examples 1 and 2 using RAS.

**[Table 3]**

| | Atom concentration (at%) | | | | | F/Ta |
|---|---|---|---|---|---|---|
| | C1s | 01s | F1s | Si2p | Ta4f | |
| Example 1 | 26.3 | 14.2 | 55.4 | 3.8 | 0.26 | 213 |
| Example 3 | 26.0 | 15.0 | 54.1 | 4.9 | 0.12 | 451 |
| Comparative Example 1 | 26.1 | 14.1 | 55.7 | 4.1 | 0.00 | - |

From the above analysis results, it was confirmed that the surface-treating layers of Examples containing Ta had better results in both the alkali immersion test and the friction durability test as compared with the surface-treating layers of Comparative Examples not containing Ta.

### Industrial Applicability

The article of the present disclosure can be suitably used in various applications, for example, as an optical member such as a touch panel.

## Claims

1. A surface-treating agent comprising: a fluorine-containing silane compound; and a metal compound,
wherein a metal atom contained in the metal compound is one or more metal atoms selected from transition metal atoms of Groups 3 to 11 and typical metal atoms of Groups 12 to 15 of the periodic table.

2. The surface-treating agent according to claim 1, wherein the fluorine-containing silane compound is at least one fluoropolyether group-containing compound represented by the following formula (1) or (2):
R^{F1} _{α} - X^{A} - R^{Si} _{β} (1)
R^{Si} _{γ} - X^{A} - R^{F2} - X^{A} - R^{Si} _{γ} (2)
wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

3. The surface-treating agent according to claim 2, wherein Rf¹ is each independently at each occurrence a C₁₋₁₆ perfluoroalkyl group; and
Rf² is each independently at each occurrence a C₁₋₆ perfluoroalkylene group.

4. The surface-treating agent according to claim 2 or 3, wherein R^{F} is each independently at each occurrence a group represented by formula:
-(OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-
wherein R^{Fa} is each independently at each occurrence a hydrogen atom, fluorine atom, or a chlorine atom; and
a, b, c, d, e and f are each independently an integer of 0 to 200, the sum of a, b, c, d, e and f is 1 or more, the occurrence order of the respective repeating units enclosed in parentheses provided with a, b, c, d, e or f is not limited in the formula, provided that when all R^{Fa} are a hydrogen atom or a chlorine atom, at least one of a, b, c, e, and f is 1 or more.

5. The surface-treating agent according to claim 4, wherein R^{Fa} is a fluorine atom.

6. The surface-treating agent according to any one of claims 2 to 5, wherein R^{F} is each independently at each occurrence a group represented by the following formula (f1), (f2), (f3), (f4), or (f5):
-(OC₃F₆)_{d}- (f1)
wherein d is an integer of 1 to 200;
-(OC₄F₈)_{c}-(OC₃F₆)_{d}-(OC₂F₄)ₑ-(OCF₂)_{f}- (f2)
wherein c and d are each independently an integer of 0 to 30;
e and f are each independently an integer of 1 to 200; the sum of c, d, e, and f is an integer of 10 to 200; and
the occurrence order of the respective repeating units enclosed in parentheses provided with a subscript c, d, e, or f is not limited in the formula;
-(R⁶-R⁷)_{g}- (f3)
wherein R⁶ is OCF₂ or OC₂F₄;
R⁷ is a group selected from OC₂F₄, OC₃F₆, OC₄F₈, OC₅F₁₀, and OC₆F₁₂, or is a combination of two or three groups selected from these groups; and
g is an integer of 2 to 100;
-(OC₆F₁₂)ₐ-(OC₅F₁₀)_{b}-(OC₄F₈)_{c}-(OC₃F₆)_{d}-(OC₂F₄)ₑ-(OCF₂)_{f}- (f4)
wherein e is an integer of 1 or more and 200 or less, a, b, c, d and f are each independently an integer of 0 or more and 200 or less, the sum of a, b, c, d, e and f is at least 1, and the occurrence order of the respective repeating units enclosed in parentheses provided with a, b, c, d, e or f is not limited in the formula; and
-(OC₆F₁₂)ₐ-(OC₅F₁₀)_{b}-(OC₄F₈)_{c}-(OC₃F₆)_{d}-(OC₂F₄)ₑ-(OCF₂)_{f}- (f5)
wherein f is an integer of 1 or more and 200 or less, a, b, c, d, and e are each independently an integer of 0 or more and 200 or less, the sum of a, b, c, d, e and f is at least 1, and the occurrence order of the respective repeating units enclosed in parentheses provided with a, b, c, d, e or f is not limited in the formula.

7. The surface-treating agent according to any one of claims 2 to 6, wherein R^{Si} is a group represented by the following formula (S1), (S2), (S3), or (S4): 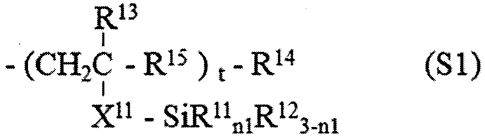
-SiR¹¹ₙ₁R¹²₃₋ₙ₁ (S2)
-SiR^{a1}ₖ₁R^{b1}₁₁R^{c1}ₘ₁ (S3)
-CR^{d1}ₖ₂R^{e1}₁₂R^{f1}ₘ₂ (S4)
wherein
R¹¹ is each independently at each occurrence a hydroxyl group or a hydrolyzable group;
R¹² is each independently at each occurrence a hydrogen atom or a monovalent organic group;
n1 is an integer of 0 to 3 each independently in each (SiR¹¹ₙ₁R¹²₃₋ₙ₁) unit;
X¹¹ is each independently at each occurrence a single bond or a divalent organic group;
R¹³ is each independently at each occurrence a hydrogen atom or a monovalent organic group;
t is each independently at each occurrence an integer of 2 or more;
R¹⁴ is each independently at each occurrence a hydrogen atom, a halogen atom, or -X¹¹-SiR¹¹ₙ₁R¹²₃₋ₙ₁;
R¹⁵ is each independently at each occurrence a single bond, an oxygen atom, an alkylene group having 1 to 6 carbon atoms or an alkyleneoxy group having 1 to 6 carbon atoms;
R^{a1} is each independently at each occurrence -Z¹-SiR²¹ₚ₁R²²_{q1}R²³ᵣ₁;
Z¹ is each independently at each occurrence an oxygen atom or a divalent organic group;
R²¹ is each independently at each occurrence -Z^{1'}-SiR^{21'}_{p1'}R^{22'}_{q1'}R^{23'}_{r1'};
R²² is each independently at each occurrence a hydroxyl group or a hydrolyzable group;
R²³ is each independently at each occurrence a hydrogen atom or a monovalent organic group;
p1 is each independently at each occurrence an integer of 0 to 3;
q1 is each independently at each occurrence an integer of 0 to 3;
r1 is each independently at each occurrence an integer of 0 to 3;
Z^{1'} is each independently at each occurrence an oxygen atom or a divalent organic group;
R^{21'} is each independently at each occurrence -Z^{1"}-SiR^{22"}_{q1"}R^{23"}_{r1"};
R^{22'} is each independently at each occurrence a hydroxyl group or a hydrolyzable group;
R^{23'} is each independently at each occurrence a hydrogen atom or a monovalent organic group;
p1' is each independently at each occurrence an integer of 0 to 3;
q1' is each independently at each occurrence an integer of 0 to 3;
r1' is each independently at each occurrence an integer of 0 to 3;
Z^{1"} is each independently at each occurrence an oxygen atom or a divalent organic group;
R^{22"} is each independently at each occurrence a hydroxyl group or a hydrolyzable group;
R^{23"} is each independently at each occurrence a hydrogen atom or a monovalent organic group;
q1" is each independently at each occurrence an integer of 0 to 3;
r1" is each independently at each occurrence an integer of 0 to 3;
R^{b1} is each independently at each occurrence a hydroxyl group or a hydrolyzable group;
R^{c1} is each independently at each occurrence a hydrogen atom or a monovalent organic group;
k1 is each independently at each occurrence an integer of 0 to 3;
11 is each independently at each occurrence an integer of 0 to 3;
m1 is each independently at each occurrence an integer of 0 to 3;
R^{d1} is each independently at each occurrence -Z²-CR³¹ₚ₂R³²_{q2}R³³ᵣ₂;
Z² is each independently at each occurrence a single bond, an oxygen atom or a divalent organic group;
R³¹ is each independently at each occurrence -Z^{2'}-CR^{32'}_{q2'}R^{33'}_{r2'};
R³² is each independently at each occurrence -Z³-SiR³⁴ₙ₂R³⁵₃₋ₙ₂;
R³³ is each independently at each occurrence a hydrogen atom, a hydroxyl group, or a monovalent organic group;
p2 is each independently at each occurrence an integer of 0 to 3;
q2 is each independently at each occurrence an integer of 0 to 3;
r2 is each independently at each occurrence an integer of 0 to 3;
Z^{2'} is each independently at each occurrence a single bond, an oxygen atom or a divalent organic group;
R^{32'} is each independently at each occurrence -Z³-SiR³⁴ₙ₂R³⁵₃₋ₙ₂;
R^{33'} is each independently at each occurrence a hydrogen atom, a hydroxyl group, or a monovalent organic group;
q2' is each independently at each occurrence an integer of 0 to 3;
r2' is each independently at each occurrence an integer of 0 to 3;
Z³ is each independently at each occurrence a single bond, an oxygen atom or a divalent organic group;
R³⁴ is each independently at each occurrence a hydroxyl group or a hydrolyzable group;
R³⁵ is each independently at each occurrence a hydrogen atom or a monovalent organic group;
n2 is each independently at each occurrence an integer of 0 to 3;
R^{e1} is each independently at each occurrence -Z³- SiR³⁴ₙ₂R³⁵₃₋ₙ₂;
R^{f1} is each independently at each occurrence a hydrogen atom, a hydroxyl group, or a monovalent organic group;
k2 is each independently at each occurrence an integer of 0 to 3;
12 is each independently at each occurrence an integer of 0 to 3; and
m2 is each independently at each occurrence an integer of 0 to 3.

8. The surface-treating agent according to any one of claims 2 to 7, wherein α, β, and γ are 1.

9. The surface-treating agent according to any one of claims 2 to 7, wherein X^{A} is each independently a trivalent organic group;
α is 1 and β is 2, or α is 2 and β is 1; and
γ is 2.

10. The surface-treating agent according to any one of claims 7 to 9, wherein the group represented by the formula (S1) is a group represented by the formula (S1-b): 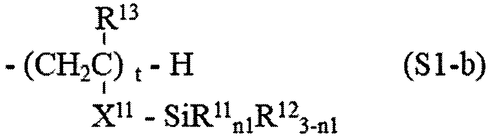 wherein R¹¹, R¹², R¹³, X¹¹, n1, and t have the same definition as described in the formula (S1).

11. The surface-treating agent according to any one of claims 1 to 10, further comprising an alcohol.

12. The surface-treating agent according to any one of claims 1 to 11, further comprising one or more other components selected from a fluorine-containing oil, a silicone oil, and a catalyst.

13. The surface-treating agent according to any one of claims 1 to 12, further comprising a solvent.

14. The surface-treating agent according to any one of claims 1 to 13, which is used as an antifouling coating agent or a water-proof coating agent.

15. The surface-treating agent according to any one of claims 1 to 14, which is for vacuum deposition.

16. A pellet comprising the surface-treating agent according to any one of claims 1 to 15.

17. An article comprising: a substrate; and a layer formed on the substrate from the surface-treating agent according to any one of claims 1 to 15.

18. An article comprising: a substrate; and a surface-treating layer formed on the substrate,
wherein the surface-treating layer is formed from a fluorine-containing silane compound and comprises one or more metal atoms selected from transition metal atoms of Groups 3 to 11 and typical metal atoms of Groups 12 to 15 of the periodic table.

19. The article according to claim 18, wherein the metal atom is contained in the surface-treating layer in an amount of 0.03 to 3 at% based on a total amount of carbon, oxygen, fluorine, silicon and the metal atom.

20. The article according to claim 18 or 19, wherein the metal atom is one or more metal atoms selected from Ta, Nb, Zr, Mo, W, Cr, Hf, Al, Ti, and V.

21. The article according to any one of claims 18 to 20, wherein the metal atom is Ta.

22. The article according to any one of claims 18 to 21, wherein the fluorine-containing silane compound is at least one fluoropolyether group-containing compound represented by the following formula (1) or (2):
R^{F1} _{α} - X^{A} - R^{Si} _{β} (1)
R^{Si} _{γ} - X^{A} - R^{F2}- X^{A} - R^{Si} _{γ} (2)
wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

23. The article according to any one of claims 17 to 22, wherein the substrate is a glass substrate.

24. The article according to any one of claim 17 to 23, which is an optical member.

25. A method for producing an article comprising a substrate and a surface-treating layer formed on the substrate,
wherein the surface-treating layer is formed from a fluorine-containing silane compound and comprises one or more metal atoms selected from transition metal atoms of Groups 3 to 11 and typical metal atoms of Groups 12 to 15 of the periodic table, and
the method comprises depositing the fluorine-containing silane compound and a metal compound containing the metal atom on the substrate using a surface-treating agent containing the fluorine-containing silane compound and the metal compound containing the metal atom to form the surface-treating layer.
